(19) Europäisches Patentamt / European Patent Office / Office européen des brevets

(11) **EP 4 278 194 B1**

(12) **EUROPÄISCHE PATENTSCHRIFT**

(45) Veröffentlichungstag und Bekanntmachung des Hinweises auf die Patenterteilung:
**19.06.2024 Patentblatt 2024/25**

(21) Anmeldenummer: **22701976.7**

(22) Anmeldetag: **26.01.2022**

(51) Internationale Patentklassifikation (IPC):
**G01R 1/20** (2006.01)

(52) Gemeinsame Patentklassifikation (CPC):
**G01R 1/203**

(86) Internationale Anmeldenummer:
**PCT/EP2022/051742**

(87) Internationale Veröffentlichungsnummer:
**WO 2022/171439 (18.08.2022 Gazette 2022/33)**

(54) **STROMMESSWIDERSTAND**

CURRENT-SENSING RESISTOR

RÉSISTANCE DE DÉTECTION DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.02.2021 DE 102021103238**
**30.09.2021 DE 202021105281 U**

(43) Veröffentlichungstag der Anmeldung:
**22.11.2023 Patentblatt 2023/47**

(73) Patentinhaber: **Isabellenhütte Heusler GmbH & Co. KG**
**35683 Dillenburg (DE)**

(72) Erfinder:
• **KRAMM, Benedikt**
**35435 Wettenberg (DE)**
• **LEBEAU, Felix**
**35745 Herborn (DE)**
• **SATTLER, Jan**
**35708 Haiger (DE)**

(74) Vertreter: **v. Bezold & Partner Patentanwälte - PartG mbB**
**Ridlerstraße 57**
**80339 München (DE)**

(56) Entgegenhaltungen:
EP-A1- 3 671 225    DE-A1-102017 003 111
DE-T5-112018 004 830

## Beschreibung

### Technisches Gebiet der Erfindung

Die Erfindung betrifft einen Strommesswiderstand zur Messung eines elektrischen Stroms gemäß der Vierleitertechnik.

### Hintergrund der Erfindung

Aus EP 0 605 800 A1 ist es bekannt, einen elektrischen Strom mittels eines niederohmigen Strommesswiderstands ("Shunt") gemäß der Vierleitertechnik zu messen. Dabei wird der zu messende elektrische Strom durch den niederohmigen Strommesswiderstand geleitet, wobei der Spannungsabfall über dem niederohmigen Strommesswiderstand gemessen wird. Der gemessene Spannungsabfall über dem niederohmigen Strommesswiderstand ist dann gemäß dem Ohmschen Gesetz ein Maß für den elektrischen Strom, der durch den niederohmigen Strommesswiderstand fließt.

Weiterhin ist aus WO 2012/019784 A1 ein weiterentwickelter niederohmiger Strommesswiderstand bekannt, bei dem die Spannungsmesskontakte des niederohmigen Strommesswiderstands von Einschnitten umgeben sind, die auch als Stromschatten bezeichnet werden und einen Stromfluss quer über den jeweiligen Einschnitt verhindern. Diese Einschnitte beeinflussen die elektrische Feldverteilung in dem niederohmigen Strommesswiderstand positiv. Nachteilig an diesem bekannten Strommesswiderstand gemäß dem Stand der Technik ist die Tatsache, dass Messfehler nicht ohne weiteres erkannt werden können.

Zum technischen Hintergrund der Erfindung ist auch hinzuweisen auf DE 10 2020 111 634 B3, DE 10 2013 005 939 A1, US 2017/0089955 A1, DE 10 2017 003 111 A1 und DE 11 2018 004 830 T5.

Schließlich offenbart EP 3 671 225 A1 einen Strommesswiderstand gemäß dem Oberbegriff von Anspruch 1. Dieser bekannte Strommesswiderstand ist jedoch noch nicht optimal.

### Beschreibung der Erfindung

Der Erfindung liegt deshalb die Aufgabe zugrunde, einen entsprechend verbesserten niederohmigen Strommesswiderstand zu schaffen.

Diese Aufgabe wird durch einen erfindungsgemäßen Strommesswiderstand gemäß dem Hauptanspruch gelöst.

Die Erfindung umfasst die allgemeine technische Lehre, an einem niederohmigen Strommesswiderstand einen Dreipunktabgriff zur Spannungsmessung vorzusehen, wobei der Dreipunktabgriff drei Spannungsmessungen an einer geschlossenen Masche ermöglicht, die sich über das Widerstandselement erstreckt. Der Dreipunktabgriff stellt also drei Messkanäle bereit, die drei Spannungsmesswerte liefern. Bei einer fehlerfreien Messung muss die Summe aller Spannungen in der geschlossenen Masche entsprechend dem Zweiten Kirchhoffschen Gesetz null sein. Bei einem Messfehler tritt jedoch eine Abweichung von null auf, was eine Fehlererkennung ermöglicht.

Der erfindungsgemäße Strommesswiderstand weist zunächst in Übereinstimmung mit dem eingangs beschriebenen bekannten Strommesswiderstand ein erstes Anschlussteil auf, das aus einem elektrisch leitfähigen Leitermaterial (z.B. Kupfer) besteht und vorzugsweise dazu dient, den zu messenden elektrischen Strom in den Strommesswiderstand einzuleiten.

Darüber hinaus weist der erfindungsgemäße Strommesswiderstand in Übereinstimmung mit dem eingangs beschriebenen bekannten Strommesswiderstand ein zweites Anschlussteil auf, das ebenfalls aus einem elektrisch leitfähigen Leitermaterial (z.B. Kupfer) besteht und vorzugsweise dazu dient, den zu messenden elektrischen Strom wieder aus dem Strommesswiderstand abzuführen.

Weiterhin hat auch der erfindungsgemäße Strommesswiderstand ein Widerstandselement aus einem Widerstandsmaterial (z.B. Manganin®), wobei das Widerstandselement in Hauptstromflussrichtung zwischen dem ersten Anschlussteil und dem zweiten Anschlussteil angeordnet ist, so dass der zu messende elektrische Strom durch das Widerstandselement fließt.

Darüber hinaus weist auch der erfindungsgemäße Strommesswiderstand zur Spannungsmessung einen ersten Spannungsmesskontakt an dem ersten Anschlussteil und einen zweiten Spannungsmesskontakt an dem zweiten Anschlussteil auf.

Der zweite Spannungsmesskontakt ist hierbei von einem Einschnitt umgeben, der auch als Stromschatten bezeichnet wird und einen Stromfluss quer über den Einschnitt verhindert. Im Gegensatz zu dem bekannten Strommesswiderstand gemäß WO 2012/019784 A1 ist bei dem erfindungsgemäßen Strommesswiderstand vorzugsweise nur in einem der beiden Anschlussteile ein Einschnitt (Stromschatten) vorgesehen, während das andere Anschlussteil keinen solchen Einschnitt enthält.

Der erfindungsgemäße Strommesswiderstand zeichnet sich nun dadurch aus, dass an dem zweiten Anschlussteil zusätzlich ein dritter Spannungsmesskontakt angeordnet ist, um die Spannung an dem zweiten Anschlussteil zu messen. Der dritte Spannungsmesskontakt an dem zweiten Anschlussteil ist hierbei bezüglich der Hauptstromflussrichtung quer zu dem zweiten Spannungsmesskontakt an dem zweiten Anschlussteil versetzt angeordnet. Die drei Spannungsmesskontakte ermöglichen also den vorstehend bereits erwähnten Dreipunktabgriff und bilden eine geschlossene Masche zur Spannungsmessung, was die vorstehend erwähnte Diagnosefunktion ermöglicht. Bei vier Spannungsmesskontakten können dann zwei solche Maschen gebildet werden, die jeweils drei Spannungsmesskontakte umfassen, wobei die Summe der Spannungen auf einem Maschenumlauf dann Null sein muss.

In einem bevorzugten Ausführungsbeispiel der Erfindung bilden der erste Spannungsmesskontakt an dem ersten Anschlussteil und der zweite Spannungsmesskontakt an dem zweiten Anschlussteil gemeinsam einen ersten Messkanal zur Spannungsmessung, wobei an dem ersten Messkanal ein erster Spannungsmesswert (U12) ausgegeben wird. Die erste Spannungsmessung an dem ersten Messkanal erfolgt hierbei vorzugsweise parallel zur Hauptstromflussrichtung in dem Strommesswiderstand. Darüber hinaus ist in diesem Ausführungsbeispiel vorgesehen, dass der erste Spannungsmesskontakt an dem ersten Anschlussteil zusammen mit dem dritten Spannungsmesskontakt an dem zweiten Anschlussteil einen zweiten Messkanal bildet, um einen zweiten Spannungsabfall (U13) über dem Widerstandselement und schräg zu der Hauptstromflussrichtung zu messen. Darüber hinaus bildet der zweite Spannungsmesskontakt an dem zweiten Anschlussteil vorzugsweise zusammen mit dem dritten Spannungsmesskontakt an dem zweiten Anschlussteil einen dritten Messkanal, um einen dritten Spannungsabfall (U23) quer zu der Hauptstromflussrichtung zu messen, insbesondere rechtwinklig zu der Hauptstromflussrichtung. Die drei Messkanäle liefern hierbei also drei Spannungsmesswerte (U12, U13, U23), die bei einer fehlerfreien Messung unter Berücksichtigung des Vorzeichens in der Summe null ergeben. Bei einer Abweichung von null liegt dagegen ein Messfehler vor.

In einem anderen Ausführungsbeispiel der Erfindung bildet dagegen der zweite Spannungsmesskontakt an dem zweiten Anschlussteil zusammen mit dem dritten Spannungsmesskontakt an dem zweiten Anschlussteil einen ersten Messkanal, um einen ersten Spannungsabfall (U23) quer zu der Hauptstromflussrichtung zu messen, insbesondere rechtwinklig zu der Hauptstromflussrichtung. In diesem Ausführungsbeispiel bildet der erste Spannungsmesskontakt an dem ersten Anschlussteil vorzugsweise zusammen mit dem dritten Spannungsmesskontakt einem zweiten Anschlussteil einen zweiten Messkanal, um einen zweiten Spannungsabfall (U13) über dem Widerstandselement schräg zu der Hauptstromflussrichtung zu messen. Darüber hinaus bildet hierbei vorzugsweise der erste Spannungsmesskontakt an dem ersten Anschlussteil zusammen mit dem zweiten Spannungsmesskontakt an dem zweiten Anschlussteil einen dritten Messkanal, um einen dritten Spannungsabfall (U12) über dem Widerstandselement und vorzugsweise parallel zu der Hauptstromflussrichtung zu messen. Auch in diesem Ausführungsbeispiel wird ein Dreipunktabgriff mit der vorstehend beschriebenen Diagnosefunktion ermöglicht.

Weiterhin besteht im Rahmen der Erfindung die Möglichkeit, dass an dem zweiten Anschlussteil ein vierter Spannungsmesskontakt angeordnet ist, der elektrisch leitend mit dem dritten Spannungsmesskontakt verbunden ist, um die Spannung gemeinsam an dem dritten Spannungsmesskontakt und an dem vierten Spannungsmesskontakt zu messen. Der dritte Spannungsmesskontakt und der vierte Spannungsmesskontakt bieten hierbei also einen gemeinsamen Spannungsabgriff.

Darüber hinaus kann an dem ersten Anschlussteil ein fünfter Spannungsmesskontakt angeordnet sein, der elektrisch leitend mit dem ersten Spannungsmesskontakt verbunden ist, um die Spannung gemeinsam an dem ersten Spannungsmesskontakt und an dem fünften Spannungsmesskontakt zu messen. Der erste Spannungsmesskontakt und der fünfte Spannungsmesskontakt bilden hierbei also einen gemeinsamen Spannungsabgriff.

Weiterhin ist zu erwähnen, dass der erste Spannungsmesskontakt an dem ersten Anschlussteil vorzugsweise bezüglich der Seitenränder des Strommesswiderstands mittig angeordnet ist, insbesondere mit einer Exzentrizität, die kleiner ist als 50%, 40%, 30%, 20%, 10% oder sogar 5% der Breite des Strommesswiderstands.

Das gleiche gilt vorzugsweise auch für den zweiten Spannungsmesskontakt und den diesen umgebenden Einschnitt in dem zweiten Anschlussteil, die ebenfalls bezüglich der Seitenränder des Strommesswiderstands vorzugsweise mittig angeordnet sind, insbesondere mit einer Exzentrizität, die kleiner ist als 50%, 40%, 30%, 20%, 10% oder 5% der Breite des Strommesswiderstands.

Der dritte Spannungsmesskontakt an dem zweiten Anschlussteil ist dagegen vorzugsweise außermittig angeordnet, damit der Dreipunktabgriff eine dreieckige Masche über dem Widerstandselement bildet.

Weiterhin ist zu erwähnen, dass der erste Spannungsmesskontakt an dem ersten Anschlussteil und der zweite Spannungsmesskontakt an dem zweiten Anschlussteil vorzugsweise im Wesentlichen den gleichen Abstand zu den Seitenrändern des Strommesswiderstands aufweisen, so dass der erste Spannungsabfall über dem Widerstandselement parallel zu der Hauptstromflussrichtung in dem Strommesswiderstand gemessen wird.

Ferner ist zu erwähnen, dass in dem zweiten Anschlussteil der dritte Spannungsmesskontakt und der optionale vierte Spannungsmesskontakt vorzugsweise im Wesentlichen den gleichen Abstand zur Mittelachse des Strommesswiderstands haben können.

Darüber hinaus ist zu erwähnen, dass in dem zweiten Anschlussteil der zweite Spannungsmesskontakt vorzugsweise zwischen dem dritten und - falls vorhanden - dem vierten Spannungsmesskontakt angeordnet ist.

Der vorstehend bereits erwähnte Einschnitt (Stromschatten) in dem zweiten Anschlussteil ist vorzugsweise bogenförmig ausgebildet, insbesondere V-förmig oder U-förmig. Die Basis des bogenförmigen Einschnitts ist hierbei vorzugsweise quer zu der Hauptstromflussrichtung in dem Strommesswiderstand ausgerichtet, während die Schenkel des bogenförmigen Einschnitts vorzugweise im Wesentlichen parallel zu der Hauptstromflussrichtung ausgerichtet und dem Widerstandselement zugewandt sind.

Hinsichtlich der Länge der Schenkel des Einschnitts bestehen im Rahmen der Erfindung verschiedene Möglichkeiten, die nachfolgend kurz beschrieben werden.

In einer Erfindungsvariante ragen die Schenkel des Einschnitts in der Hauptstromflussrichtung bis in das Widerstandselement hinein und enden in dem Widerstandselement. Hierbei besteht wiederum die Möglichkeit, dass die beiden Schenkel gleich weit in das Widerstandselement hineinragen oder unterschiedlich weit. Die Schenkellänge innerhalb des Widerstandselements kann hierbei beispielsweise im Bereich von 0,1 mm - 3 mm, 0,2 mm - 2 mm, 0,5 mm - 1,5 mm oder bei ungefähr 1 mm liegen.

In einer anderen Erfindungsvariante enden die Schenkel des Einschnitts dagegen in der Hauptstromflussrichtung vor dem Widerstandselement, d.h. die Schenkel des Einschnitts ragen nicht bis in das Widerstandselement hinein. Hierbei können die Schenkel einen Abstand zu dem Widerstandselement aufweisen, der beispielsweise im Bereich von 0,1 mm - 3 mm, 0,2 mm - 2 mm, 0,5 mm - 1,5 mm oder bei 1 mm liegen kann.

In einer dritten Erfindungsvariante reichen die Schenkel des Einschnitts dagegen genau bis zu der Grenze zwischen dem Widerstandselement und dem zweiten Anschlussteil.

Ferner ist zu erwähnen, dass in dem zweiten Anschlussteil der zweite Spannungsmesskontakt und der umgebende Einschnitt alternativ auch außermittig angeordnet sein können. Dies bedeutet, dass der zweite Spannungsmesskontakt und der umgebende Einschnitt zu dem einen Seitenrand des Strommesswiderstands einen geringeren Abstand hat als zu dem gegenüberliegenden Seitenrand. Hierbei geht der Einschnitt vorzugsweise von der näher liegenden Seitenkante des Strommesswiderstands aus und erstreckt sich bogenförmig oder L-förmig bis in das Widerstandselement hinein oder zumindest bis zu der Grenze zwischen dem zweiten Anschlussteil und dem Widerstandselement.

Allgemein ist zu erwähnen, dass die Erfindung nicht auf ein bestimmtes Leitermaterial der Anschlussteile beschränkt ist. Beispielsweise kann es sich bei dem Leitermaterial um Kupfer, eine Kupferlegierung, Aluminium oder eine Aluminiumlegierung handeln.

Es ist jedoch zu erwähnen, dass das Leitermaterial der Anschlussteile typischerweise einen kleineren spezifischen elektrischen Widerstand aufweist als das Widerstandsmaterial des Widerstandselements.

Auch hinsichtlich des Widerstandsmaterials des Widerstandselements ist die Erfindung nicht auf ein bestimmtes Widerstandsmaterial beschränkt. Beispielsweise kann eine Kupfer-Legierung verwendet werden, wie beispielsweise eine Kupfer-Mangan-Legierung. Beispiele hierfür sind CuMn12Ni2 oder CuMn7Sn2,3. Weiterhin kann auch eine Kupfer-Mangan-Nickel-Legierung verwendet werden, wie beispielsweise Cu84Ni4Mn12 oder Cu65Mn25Ni10. Darüber hinaus kann alternativ auch eine Kupfer-Chrom-Legierung verwendet werden oder eine Nickel-Legierung.

In dem bevorzugten Ausführungsbeispiel der Erfindung ist das Widerstandselement elektrisch und mechanisch mit den beiden angrenzenden Anschlussteilen verbunden, beispielsweise durch eine Schweißverbindung, wobei sich eine Elektronenschweißverbindung als besonders vorteilhaft erwiesen hat.

Das Widerstandsmaterial des Widerstandselements hat vorzugsweise einen relativ kleinen spezifischen elektrischen Widerstand, der vorzugsweise kleiner ist als $2 \cdot 10^{-4}$ $\Omega \cdot$m, $2 \cdot 10^{-5}$ $\Omega \cdot$m oder $2 \cdot 10^{-6}$ $\Omega \cdot$m. Der spezifische elektrische Widerstand des Widerstandsmaterials ist dagegen vorzugsweise größer als $2 \cdot 10^{-6}$ $\Omega \cdot$m, $2 \cdot 10^{-7}$ $\Omega \cdot$m.

Das Leitermaterial der Anschlussteile hat dagegen vorzugsweise einen noch geringeren spezifischen elektrischen Widerstand, der vorzugsweise kleiner ist als $10^{-6}$ $\Omega \cdot$m oder $10^{-7}$ $\Omega \cdot$m.

Es wurde bereits vorstehend erwähnt, dass der Strommesswiderstand in dem bevorzugten Ausführungsbeispiel niederohmig ist. Beispielsweise kann der Widerstandswert höchstens 1 $\mu\Omega$, 10 $\mu\Omega$, 20 $\mu\Omega$, 33 $\mu\Omega$, 50 $\mu\Omega$, 100 $\mu\Omega$, 500 $\mu\Omega$, 10 m$\Omega$, 5 m$\Omega$, 2 m$\Omega$ oder 1 m$\Omega$ betragen.

Ferner ist zu erwähnen, dass der erfindungsgemäße Strommesswiderstand eine Strombelastbarkeit aufweisen kann, die bei einer Dauerbelastung mindestens 1 A, 10 A, 100 A, 1 kA oder sogar 5 kA erlaubt.

Zu der konstruktiven Gestaltung des Strommesswiderstands ist zu erwähnen, dass das Widerstandselement und die Anschlussteile vorzugsweise jeweils plattenförmig ausgebildet sind, wobei die plattenförmigen Teile wahlweise eben oder gebogen sein können.

Die Länge des Strommesswiderstands in der Hauptstromflussrichtung ist vorzugsweise kleiner als 30 cm, 20 cm, 10 cm, 5 cm, 2 cm oder 1 cm, während die Breite vorzugsweise kleiner ist als 20 cm, 10 cm, 5 cm, 2cm oder 1 cm. Die Dicke des Strommesswiderstands ist dagegen vorzugsweise kleiner als 10 mm, 5 mm, 4 mm, 2mm oder 1 mm.

Darüber hinaus ist zu erwähnen, dass die beiden Anschlussteile jeweils einen Stromanschluss aufweisen können, um den elektrischen Strom in den Strommesswiderstand einzuleiten oder auszuleiten, wobei diese Stromanschlüsse beispielsweise aus einer Bohrung bestehen können, die eine Schraube aufnehmen kann, wie an sich aus EP 0 605 800 A1 bekannt ist.

Die einzelnen Spannungsmesskontakte können jeweils als Kontaktinseln ausgebildet sein, die aus einer elektrisch leitfähigen Beschichtung auf dem jeweiligen Anschlussteil bestehen. Diese Kontaktinseln können beispielsweise im Wesentlichen rechteckig sein, wobei das Beschichtungsmaterial der Kontaktinseln aus einem anderen Leitermaterial bestehen kann als die darunterliegenden Anschlussteile.

Ferner ist zu erwähnen, dass in das Widerstandselement einseitig oder beidseitig Trimmschnitte eingebracht werden können, um den Widerstandswert des Strommesswiderstands und/oder den Temperaturkoeffizienten des Widerstandswerts des Strommesswiderstands einzustellen.

In dem bevorzugten Ausführungsbeispiel der Erfindung weist der Strommesswiderstand Spannungsmesskontakte für genau drei Spannungsmesskanäle auf, um den eingangs erwähnten Dreipunktabgriff zu ermöglichen. Der Dreipunktabgriff ermöglicht hierbei eine Spannungsmessung entlang einer geschlossenen Masche über dem Widerstandselement, was eine Diagnosefunktion ermöglicht.

Vorstehend wurde der erfindungsgemäße Strommesswiderstand als einzelnes Bauteil beschrieben. Die Erfindung beansprucht jedoch auch Schutz für eine Strommesseinrichtung mit einem solchen Strommesswiderstand und einer Spannungsmesseinrichtung zur getrennten Spannungsmessung an den einzelnen Messkanälen des Strommesswiderstands.

Darüber hinaus kann die Strommesseinrichtung auch eine Auswertungseinheit aufweisen, um den durch den Strommesswiderstand fließenden Strom aus den verschiedenen Spannungsmesswerten zu ermitteln. Hierbei kann die Auswertungseinheit auch eine Diagnosefunktion erfüllen. Hierzu kann die Spannungsmesseinrichtung die Spannungen an den drei Messkanälen des Dreipunktabgriffs messen und dann die Spannungsabweichung berechnen, die bei einer Umlaufmessung entlang der geschlossenen Masche auftritt. Die Auswertungseinheit kann dann ein Fehlersignal erzeugen, wenn die Abweichung einen zulässigen Maximalwert übersteigt.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.

Kurzbeschreibung der Zeichnungen

Figur 1A zeigt eine Perspektivansicht eines erfindungsgemäßen Strommesswiderstands mit einem Dreipunktabgriff.

Figur 1B zeigt eine Aufsicht auf den Strommesswiderstand gemäß Figur 1A.

Figur 2A zeigt eine Aufsicht auf einen erfindungsgemäßen Strommesswiderstand ähnlich dem Strommesswiderstand gemäß den Figuren 1A und 1B.

Figur 2B zeigt eine Abwandlung des Strommesswiderstands aus Figur 2A, wobei die Schenkel des Einschnitts an der Grenze zu dem Widerstandselement enden.

Figur 2C zeigt eine Abwandlung des Strommesswiderstands gemäß Figur 2A, wobei die Schenkel des Einschnitts nicht bis in das Widerstandselement hineinreichen.

Figur 3 zeigt den Verlauf des Widerstandswerts in Abhängigkeit von der Einschnittlänge der Schenkel innerhalb des Widerstandselements.

Figur 4 zeigt eine vergrößerte Detailansicht des Strommesswiderstands aus den Figuren 1A und 1B im Bereich des Einschnitts.

Figur 5 zeigt die Änderung des Widerstandswerts in Abhängigkeit von der Temperatur für unterschiedliche Längen des Einschnitts innerhalb und außerhalb des Widerstandselements.

Figur 6 zeigt die Änderung des Widerstandswerts in Abhängigkeit der Temperatur ebenfalls für unterschiedliche Einschnittlängen innerhalb und außerhalb des Widerstandselements.

Figur 7 zeigt eine erfindungsgemäße Strommesseinrichtung mit dem erfindungsgemäßen Strommesswiderstand.

Figur 8 zeigt eine Aufsicht auf ein abgewandeltes Ausführungsbeispiel eines erfindungsgemäßen Strommesswiderstands.

Figur 9 zeigt eine Perspektivansicht eines abgewandelten Ausführungsbeispiels eines erfindungsgemäßen Strommesswiderstands.

Figur 10 zeigt ein Flussdiagramm zur Verdeutlichung eines erfindungsgemäßen Diagnoseverfahrens.

Figur 11A zeigt eine Abwandlung des Ausführungsbeispiels gemäß Figur 9 mit zwei zusätzlichen Einschnitten zur Beeinflussung des Temperaturverhaltens.

Figur 11B zeigt ein Diagramm zur Verdeutlichung des Temperaturverhaltens bei dem Ausführungsbeispiel gemäß Figur 11A.

Figuren 12-17 zeigen verschiedene Abwandlungen des Ausführungsbeispiels gemäß Figur 11A.

Detaillierte Beschreibung der Zeichnungen

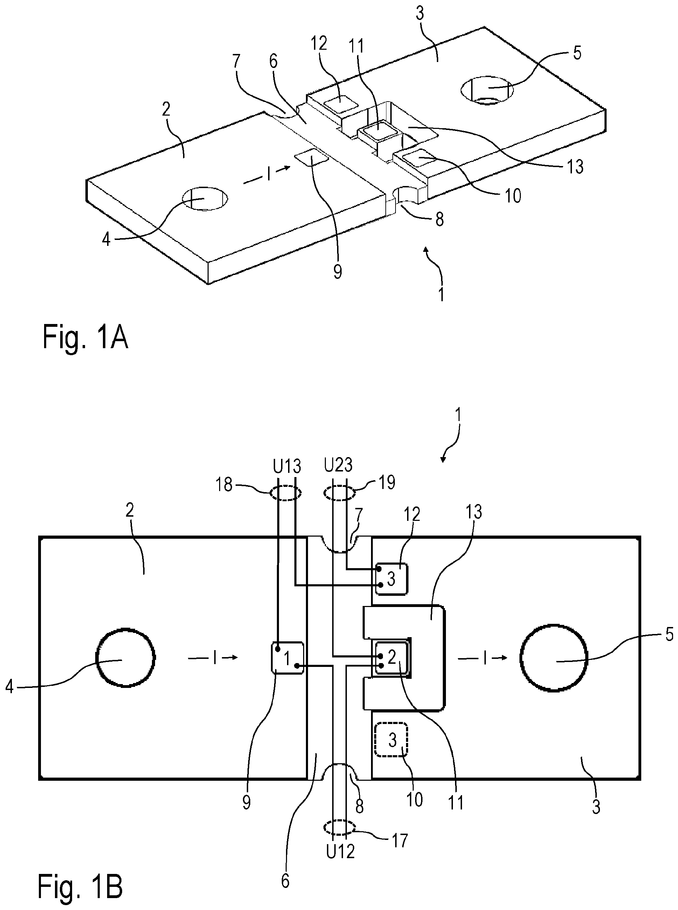

Im Folgenden wird nun das Ausführungsbeispiel eines erfindungsgemäßen Strommesswiderstands 1 beschrieben, das in den Figuren 1A und 1B dargestellt ist. So dient der Strommesswiderstand 1 zur Strommessung gemäß der Vierleitertechnik, was an sich aus dem Stand der Technik bekannt ist.

Zunächst weist der Strommesswiderstand 1 ein erstes plattenförmiges Anschlussteil 2 aus Kupfer auf, das dazu dient, einen elektrischen Strom I in den Strommesswiderstand 1 einzuleiten.

Darüber hinaus weist der Strommesswiderstand 1 ein plattenförmiges Anschlussteil 3 auf, das ebenfalls aus Kupfer besteht und dazu dient, den elektrischen Strom I wieder aus dem Strommesswiderstand 1 auszuleiten.

In den beiden Anschlussteilen 2, 3 befindet sich hierbei jeweils eine Bohrung 4 bzw. 5 zur Durchführung einer Schraube zur Stromkontaktierung, wie es bereits aus EP 0 605 800 A1 bekannt ist.

Zwischen den beiden Anschlussteilen 2, 3 befindet sich hierbei ein Widerstandselement 6 aus einem Widerstandsmaterial (z.B. Manganin®), wobei das Widerstandselement 6 an seinen Kanten jeweils durch eine Elektronenstrahlverschweißung mit den beiden Anschlussteilen 2 bzw. 3 verbunden ist.

In dem Widerstandselement 6 befinden sich seitlich Trimmschnitte 7, 8 zur Einstellung des Widerstandswerts und des Temperaturkoeffizienten des Strommesswiderstands 1, wie es an sich aus dem Stand der Technik bekannt ist.

An der Oberseite des Strommesswiderstands 1 befinden sich an den beiden Anschlussteilen 2, 3 vier Spannungsmesskontakte 9, 10, 11, 12 zur Messung der über dem Widerstandselement 6 abfallenden elektrischen Spannung und auch zur Ermöglichung einer Diagnosefunktion, wie noch detailliert beschrieben wird.

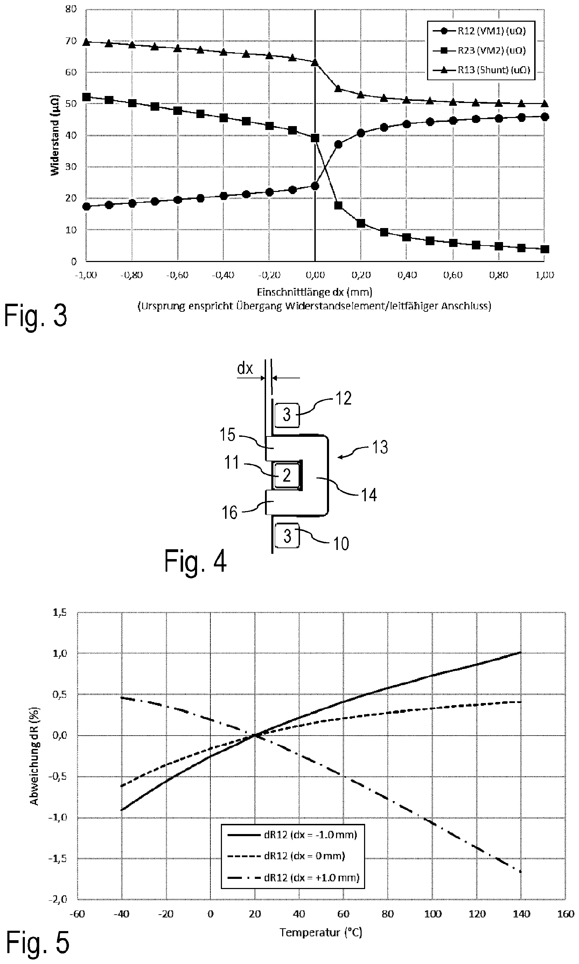

Der Spannungsmesskontakt 11 in dem zweiten Anschlussteil 3 ist hierbei mittig angeordnet und von einem Einschnitt 13 umgeben, der auch als Stromschatten bezeichnet wird und einen Stromfluss rechtwinklig über den Einschnitt 13 verhindert. Der Einschnitt 13 ist hierbei U-förmig mit einer Basis 14 rechtwinklig zur Hauptstromflussrichtung in dem Strommesswiderstands 1 und zwei Schenkeln 15, 16, die parallel zur Hauptstromflussrichtung in dem Strommesswiderstand 1 ausgerichtet sind und dem Widerstandselement 6 zugewandt sind, wobei die Schenkel 15, 16 des Einschnitts 13 in diesem Ausführungsbeispiel bis in das Widerstandselement 6 hineinragen (vgl. Fig. 4).

Der Spannungsmesskontakt 9 bildet hierbei zusammen mit dem Spannungsmesskontakt 11 einen ersten Messkanal 17, an dem ein entsprechender Spannungsmesswerte U12 ausgegeben wird.

Weiterhin bildet der Spannungsmesskontakt 9 mit dem Spannungsmesskontakt 12 einen zweiten Messkanal 18, an dem ein weiterer Spannungsmesswerte U13 ausgegeben wird.

Schließlich bildet der Spannungsmesskontakt 11 zusammen mit dem Spannungsmesskontakt 12 einen dritten Messkanal 19, an dem ein weiterer Spannungsmesswerte Wert U23 ausgegeben wird.

Die Spannungsmesskontakte 9, 11 und 12 bilden hierbei eine geschlossene Masche über dem Widerstandselement 6, so dass die Summe aller Spannungen in der Masche entsprechend dem Zweiten Kirchhoffschen Gesetz null sein muss. Die Spannungsabgriffe 9, 11, 12 bilden hierbei also einen Dreipunktabgriff, was eine Diagnosefunktion ermöglicht, wie später noch detailliert beschrieben wird.

Der optionale Spannungsmesskontakt 10 ist hierbei leitend mit dem Spannungsmesskontakt 12 verbunden, so dass die Spannungsmesskontakte 10, 12 einen gemeinsamen Spannungsabgriff bilden.

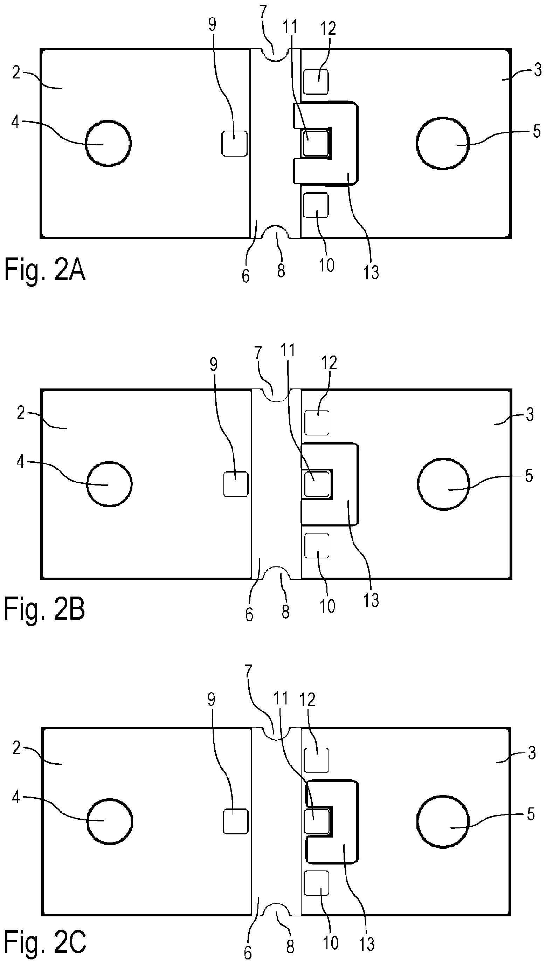

Das Ausführungsbeispiel gemäß Figur 2A stimmt weitgehend mit dem vorstehend beschriebenen Ausführungsbeispiel überein, so dass zur Vermeidung von Wiederholungen auf die vorstehende Beschreibung verwiesen wird, wobei für entsprechende Einzelheiten dieselben Bezugszeichen verwendet werden. Auch bei diesem Ausführungsbeispiel ragen die beiden Schenkel 15, 16 des U-förmigen Einschnitts 13 bis in das Widerstandselement 6 hinein.

Bei der Variante gemäß Figur 2B ragen die Schenkel 15, 16 des U-förmigen Einschnitts 13 dagegen nicht bis in das Widerstandselement 6 hinein, sondern enden an der Grenze zwischen dem Widerstandselement 6 und dem Anschlussteil 3.

Bei der Variante gemäß Figur 2C enden die Schenkel 15, 16 des U-förmigen Einschnitts 13 dagegen sogar innerhalb des Anschlussteils 3 und reichen somit nicht bis zu der Grenze zwischen dem Widerstandselement 6 und dem Anschlussteil 3.

Figur 4 zeigt eine Vergrößerung bei dem Ausführungsbeispiel gemäß Figur 1B im Bereich des U-förmigen Einschnitts 13. Hierbei ist zu erkennen, dass die Schenkel 15, 16 des U-förmigen Einschnitts 13 mit einer Länge dx bis in das Widerstandselement 6 hineinragen.

Figur 3 zeigt hierbei die Abhängigkeit des Widerstandswerts von der Einschnittlänge dx für die Teil-Widerstände R12, R13, R23 des Dreipunktabgriffs (U12, U13, U23).

Weiterhin zeigt Figur 5 die relative Änderung dR12 des Widerstandswerts R12 in Abhängigkeit von der Temperatur für verschiedene Werte von dx.

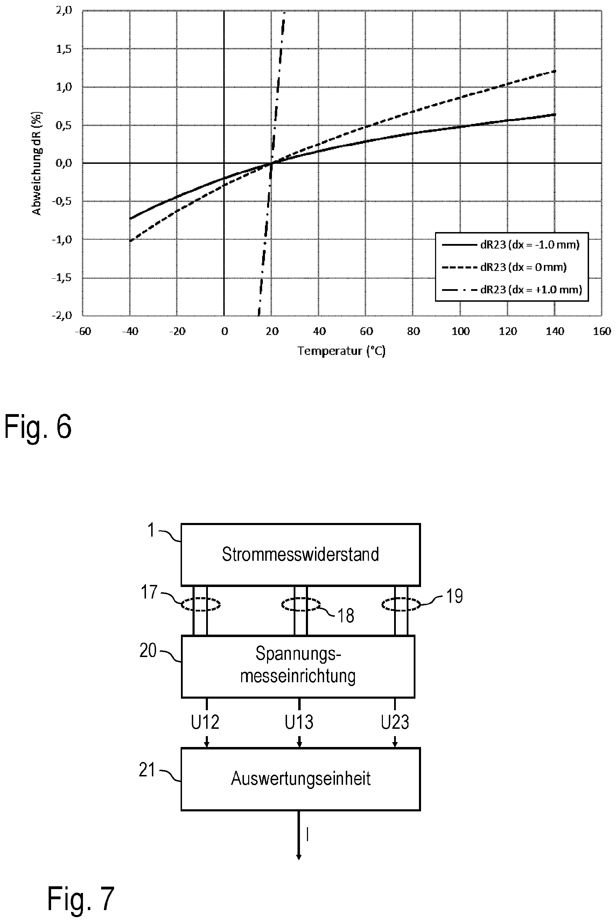

Ein weiteres solches Diagramm für R23 ist auch in Figur 6 dargestellt.

Figur 7 zeigt nun den erfindungsgemäßen Strommesswiderstand 1 nicht mehr als einzelnes Bauteil, sondern als Bestandteil einer Strommesseinrichtung.

Die Spannungsmesskanäle 17, 18 und 19 werden hierbei von einer Spannungsmesseinrichtung 20 ausgelesen, welche die drei Spannungsmesswerte U12, U13 und U23 erfasst. Die Spannungsmesseinrichtung 20 gibt die Spannungsmesswerte U12, U13, U23 dann an eine Auswertungseinheit 21 weiter, die zwei Funktionen hat.

Zum einen berechnet die Auswertungseinheit 21 aus den Spannungsmesswerten U12, U13, U23 entsprechend dem Ohmschen Gesetz den Strom I, der durch den Strommesswiderstand 1 fließt.

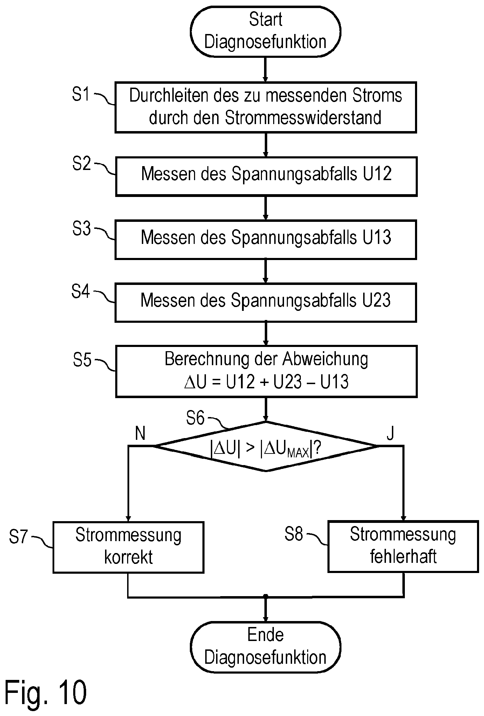

Zum anderen erfüllt die Auswertungseinheit 21 aber auch eine Diagnosefunktion, um Messfehler zu erkennen, wobei die Diagnosefunktion nachfolgend unter Bezugnahme auf das Flussdiagramm in Figur 10 beschrieben wird. So wurde bereits vorstehend erwähnt, dass die Spannungsmesswerte U12, U13, U23 die Spannungen in einer geschlossenen Masche wiedergeben und somit entsprechend dem Zweiten Kirchhoffschen Gesetz in der Summe null sein müssen.

Das erfindungsgemäße Diagnoseverfahren sieht deshalb in einem Schritt S1 vor, dass der zu messende Strom durch den Strommesswiderstand 1 durchgeleitet wird.

In den Schritten S2-S4 werden dann die Spannungsabfälle U12, U13, U23 gemessen.

Im nächsten Schritt S5 erfolgt dann die Berechnung einer Abweichung ΔU=U12+U23-U13.

Im nächsten Schritt S6 wird dann geprüft, ob die Abweichung ΔU einen vorgegebenen Maximalwert ΔU$_{MAX}$ überschreitet.

Falls dies der Fall ist, so wird in einem Schritt S8 angenommen, dass die Strommessung fehlerhaft war.

Andernfalls wird dagegen in einem Schritt S7 angenommen, dass die Strommessung korrekt war.

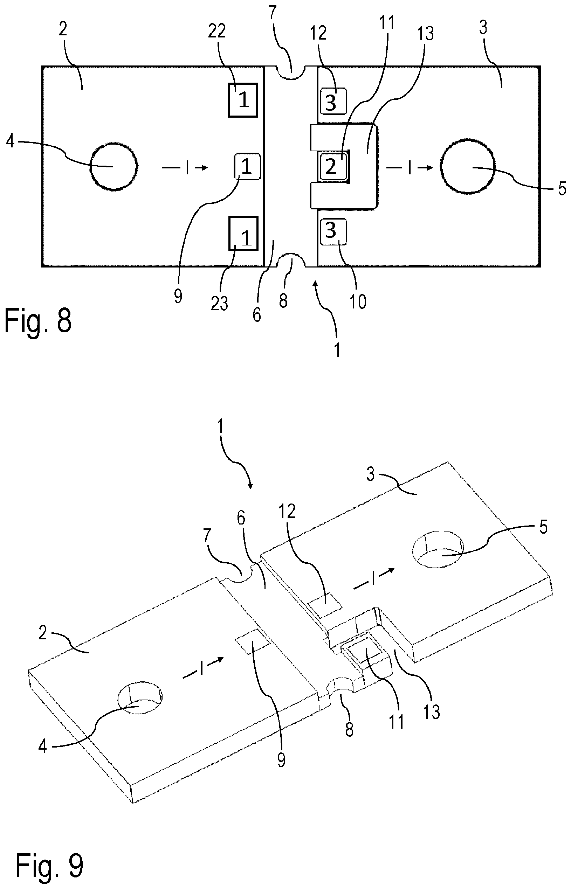

Figur 8 zeigt eine Abwandlung der vorstehend beschriebenen Ausführungsbeispiele, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass in dem Anschlussteil 2 neben dem Spannungsmesskontakt 9 weitere Spannungsmesskontakte 22, 23 angeordnet sind, die jedoch mit dem Spannungsmesskontakt 9 einen gemeinsamen Spannungsabgriff bilden.

Das Ausführungsbeispiel gemäß Figur 9 stimmt wieder teilweise mit den vorstehend beschriebenen Ausführungsbeispielen überein, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Einschnitt 13 nicht U-förmig ist, sondern L-förmig. Der L-förmige Einschnitt 13 geht hierbei von einem Seitenrand des Strommesswiderstands 1 aus und ragte mit dem anderen Schenkel dann bis in das Widerstandselement 6 hinein.

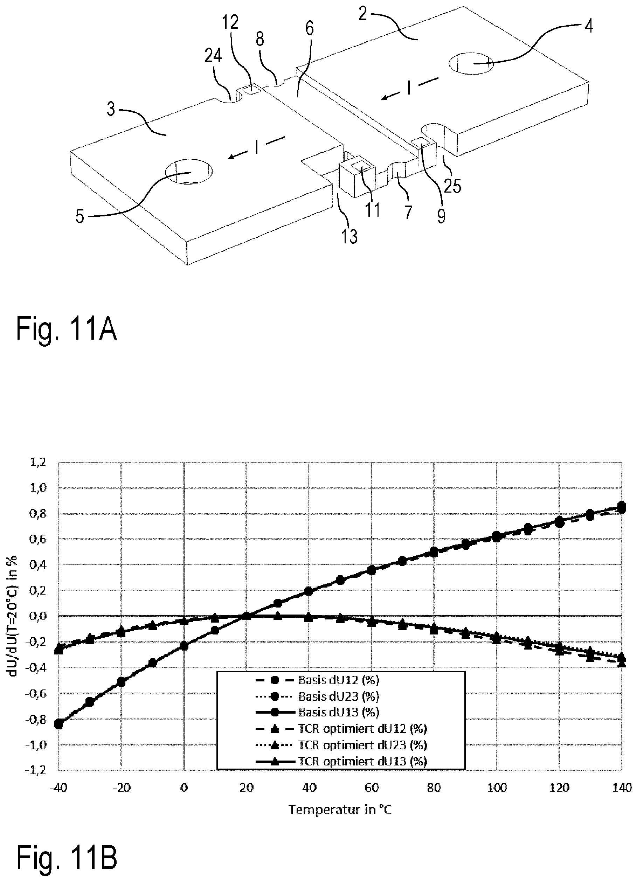

Das Ausführungsbeispiel gemäß Figur 11A stimmt weitgehend mit dem Ausführungsbeispiel gemäß Figur 9 überein, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass in dem Anschlussteil 3 seitlich ein weiterer Einschnitt 24 angeordnet ist, der einen Stromfluss quer über den Einschnitt 24 verhindert.

Der Einschnitt 24 geht hierbei vom seitlichen Rand des Anschlussteils 3 aus und verläuft quer zur Hauptstromflussrichtung in dem Strommesswiderstand 1.

Zwischen dem Einschnitt 24 und dem Widerstandselement 6 liegt hierbei der Spannungsmesskontakt 12 auf einer Kontaktinsel, die von dem Einschnitt 24 abgetrennt wird.

Darüber hinaus ist auch in dem Anschlussteil 2 ein Einschnitt 25 angeordnet, der einen Stromfluss quer über den Einschnitt 25 verhindert.

Der Einschnitt 25 geht hierbei von dem gegenüber liegenden seitlichem Rand des Anschlussteils 2 aus und erstreckt sich quer zur Hauptstromflussrichtung in dem Strommesswiderstand 1. Die beiden Einschnitte 24, 25 sind also auf gegenüberliegenden Seiten des Strommesswiderstands 1 angeordnet, wobei die beiden Einschnitte 24, 25 hierbei eine unterschiedliche Länge haben, d.h. der Einschnitt 25 ist länger als der Einschnitt 24.

Zwischen dem Einschnitt 25 und dem Widerstandselement 6 liegt hierbei der Spannungsmesskontakt 9 auf einer Kontaktinsel, die von dem Einschnitt 25 abgetrennt wird.

Die Einschnitte 24, 25 verbessern das Temperaturverhalten der Strommesswiderstands 1, wie aus dem Diagramm gemäß Figur 11B ersichtlich ist. So zeigen die verschiedenen Kennlinien in Figur 11B die relative Änderung verschiedener Spannungsmesswerte U12, U23 und U13 in Abhängigkeit von der Temperatur. Die Spannung U12 wird hierbei zwischen den beiden Spannungsmesskontakten 9, 11 gemessen, während die Spannung U23 zwischen den beiden Spannungsmesskontakten 11, 12 gemessen wird. Schließlich wird die Spannung U13 zwischen den Spannungsmesskontakten 9, 12 gemessen. In dem Diagramm zeigen die runden Messpunkte die Temperaturabhängigkeit ohne die Einschnitte 24, 25, während die dreieckigen Messpunkte den entsprechenden Verlauf für das Ausführungsbeispiel gemäß Figur 11A mit den Einschnitten 24, 25 zeigt. Der Vergleich der verschiedenen Kennlinien zeigt deutlich, dass die Temperaturabhängigkeit der Spannungsmesswerte durch die beiden Einschnitte 24, 25 deutlich verringert wird.

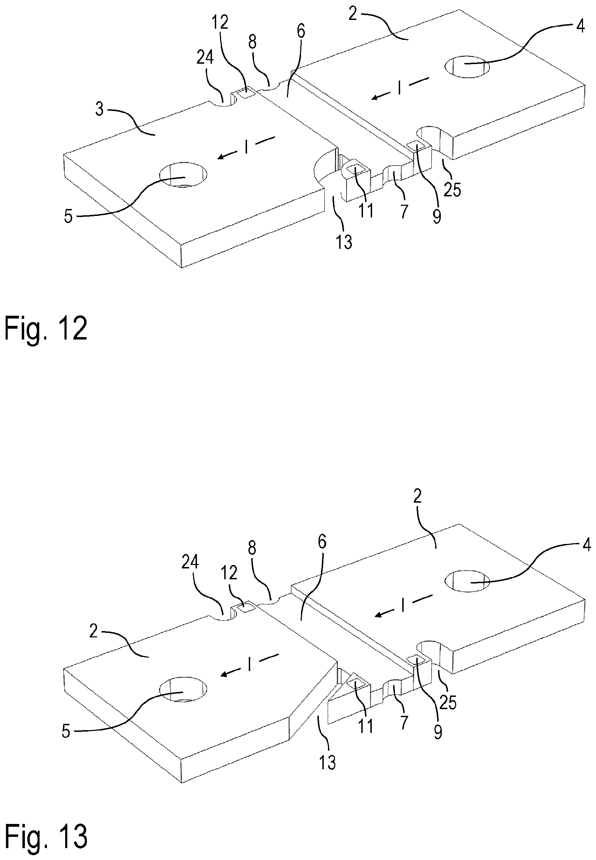

Das Ausführungsbeispiel gemäß Figur 12 stimmt weitgehend mit dem vorstehend beschriebenen und in Figur 11A dargestellten Ausführungsbeispiel überein, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Einschnitt 13 nicht L-förmig ist, sondern kreisbogenförmig.

Figur 13 zeigt eine weitere Abwandlung des Ausführungsbeispiels gemäß Figur 11A, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Einschnitt 13 hierbei weder L-förmig noch kreisbogenförmig ist, sondern gerade verläuft und schräg zur Seitenkante des Strommesswiderstands 1 ausgerichtet ist.

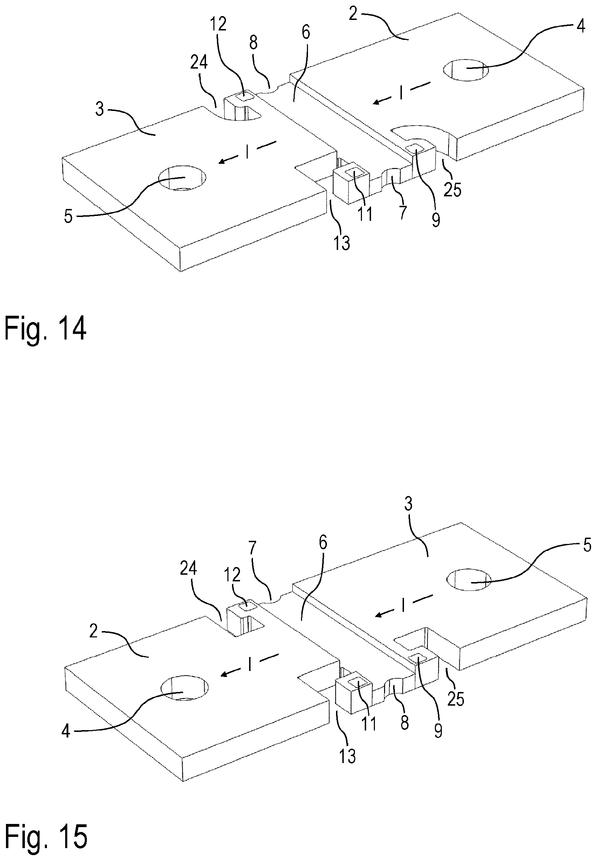

Figur 14 zeigt ein weiteres abgewandeltes Ausführungsbeispiel, das weitgehend mit dem vorstehend beschriebenen und in Figur 11A dargestellten Ausführungsbeispiel übereinstimmt, so dass zur Vermeidung von Wiederholungen wieder auf die vorstehende Beschreibung verwiesen werden kann.

Eine Besonderheit dieses Ausführungsbeispiels besteht darin, dass die beiden Einschnitte 24, 25 hierbei kreisbogenförmig sind. Die beiden Einschnitte 24, 25 gehen hierbei von gegenüberliegenden Seitenkanten des Strommesswiderstands 1 aus und verlaufen dann bogenförmig in Richtung des Widerstandselements 6, wobei sich die Einschnitte 24, 25 nicht bis zu dem Widerstandselement 6 erstrecken.

Figur 15 zeigt eine weitere Abwandlung des Ausführungsbeispiels gemäß Figur 11A, so dass zur Vermeidung von Wiederholungen wieder auf die vorstehende Beschreibung zu Figur 11A verwiesen wird, wobei für entsprechende Einzelheiten dieselben Bezugszeichen verwendet werden.

Eine Besonderheit dieses Ausführungsbeispiels besteht darin, dass die beiden Einschnitte 24, 25 hierbei L-förmig sind. Die beiden Einschnitte 24, 25 gehen hierbei von gegenüberliegenden Seitenkanten des Strommesswiderstands 1 aus und sind dann in Richtung auf das Widerstandselement 6 abgewinkelt, wobei die Einschnitte 24, 25 nicht bis zu dem Widerstandselement 6 erreichen.

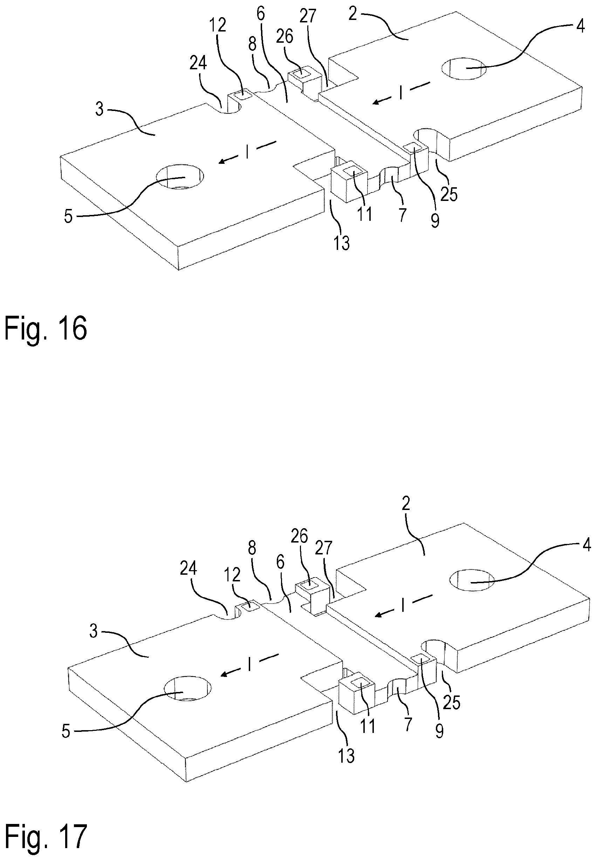

Figur 16 zeigt eine weitere Abwandlung von Figur 11A, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass in dem Anschlussteil 2 zusätzlich ein weiterer Spannungsmesskontakt 26 vorgesehen ist, wobei sich der Spannungsmesskontakt 26 an einer Seitenkante des Anschlussteils 2 angrenzend an das Widerstandselement 6 befindet.

Darüber hinaus weist das Anschlussteil 2 einen weiteren Einschnitt 27 auf, der vom Seitenrand des Anschlussteils 2 ausgeht und sich dann L-förmig bis in das Widerstandselement 6 hinein erstreckt, wobei der Einschnitt 27 in dem Anschlussteil 2 eine Kontaktinsel für den Spannungsmesskontakt 26 abtrennt.

In diesem Ausführungsbeispiel weist der Strommesswiderstand 1 also vier Spannungsmesskontakte 9, 11, 12, 26 auf, was vielfältige Spannungsmessungen ermöglicht.

Das Ausführungsbeispiel gemäß Figur 17 stimmt weitgehend mit dem vorstehend beschriebenen und in Figur 16 dargestellten Ausführungsbeispiel überein, so dass zur Vermeidung von Wiederholungen auf die vorstehende Beschreibung verwiesen wird, wobei für entsprechende Einzelheiten dieselben Bezugszeichen verwendet werden.

Bezugszeichenliste:

| | |
|---|---|
| 1 | Strommesswiderstand |
| 2 | Anschlussteil zum Einleiten des Stroms in den Strommesswiderstand |
| 3 | Anschlussteil zum Ausleiten des Stroms aus dem Strommesswiderstand |
| 4 | Bohrung in dem Anschlussteil zum Einleiten des Stroms |
| 5 | Bohrung in dem Anschlussteilen zum Ausleiten des Stroms |
| 6 | Widerstandselement zwischen den Anschlussteilen |
| 7, 8 | Trimmschnitte in dem Widerstandselement |
| 9-12 | Spannungsmesskontakte |
| 13 | U-förmiger Einschnitt in dem Anschlussteil |
| 14 | Basis des U-förmigen Einschnitts |
| 15, 16 | Schenkel des U-förmigen Einschnitts |
| 17-19 | Messkanäle der Spannungsmesseinrichtung |
| 20 | Spannungsmesseinrichtung |
| 21 | Auswertungseinheit |
| 22, 23 | Spannungsmesskontakte |
| 24 | Einschnitt in dem Anschlussteil |
| 25 | Einschnitt in dem Anschlussteil |
| 26 | Spannungsmesskontakt |
| 27 | Einschnitt in dem Anschlussteil |
| I | Strom durch den Strommesswiderstand |
| dx | Länge der Schenkel des U-förmigen Einschnitts innerhalb des Widerstandselements |
| U12 | Spannungsmesswert |
| U13 | Spannungsmesswert |
| U23 | Spannungsmesswert |
| R12 | Widerstandsmesswert |
| R13 | Widerstandsmesswert |
| R23 | Widerstandsmesswert |
| dR12 | Relative Änderung des Widerstandsmesswerts |
| dR13 | Relative Änderung des Widerstandsmesswerts |
| dR23 | Relative Änderung des Widerstandsmesswerts |

**Patentansprüche**

1. Strommesswiderstand (1) zur Messung eines elektrischen Stroms (I), mit

a) einem ersten Anschlussteil (2) aus einem elektrisch leitfähigen Leitermaterial, insbesondere zum Einleiten des zu messenden elektrischen Stroms (I) in den Strommesswiderstand (1),

b) einem zweiten Anschlussteil (3) aus einem elektrisch leitfähigen Leitermaterial, insbesondere zum Abführen des zu messenden elektrischen Stroms (I) aus dem Strommesswiderstand (1),

c) einem Widerstandelement (6) aus einem Widerstandsmaterial, wobei das Widerstandselement (6) in Hauptstromflussrichtung zwischen dem ersten Anschlussteil (2) und dem zweiten Anschlussteil (3) angeordnet ist, so dass der zu messende Strom (I) durch das Widerstandselement (6) fließt,

d) einem ersten Spannungsmesskontakt (9) an dem ersten Anschlussteil (2) zur Spannungsmessung an dem ersten Anschlussteil (2),

e) einem zweiten Spannungsmesskontakt (11) an dem zweiten Anschlussteil (3) zur Spannungsmessung an dem zweiten Anschlussteil (3), und

f) einem ersten Einschnitt (13) in dem zweiten Anschlussteil (3), wobei der erste Einschnitt (13) den zweiten Spannungsmesskontakt (11) umgibt und einen Stromfluss quer über den ersten Einschnitt (13) verhindert,

**dadurch gekennzeichnet,**

g) **dass** an dem zweiten Anschlussteil (3) ein dritter Spannungsmesskontakt (12) angeordnet ist, um die Spannung an dem zweiten Anschlussteil (3) zu messen, und

h) **dass** der dritte Spannungsmesskontakt (12) an dem zweiten Anschlussteil (3) bezüglich der Hauptstromflussrichtung quer zu dem zweiten Spannungsmesskontakt (11) an dem zweiten Anschlussteil (3) versetzt angeordnet ist.

2. Strommesswiderstand (1) nach Anspruch 1, **dadurch gekennzeichnet,**

a) **dass** der erste Spannungsmesskontakt (9) an dem ersten Anschlussteil (2) zusammen mit dem zweiten Spannungsmesskontakt (11) an dem zweiten Anschlussteil (3) einen ersten Messkanal (17) bildet, um einen ersten Spannungsabfall (U12) über dem Widerstandselement (6) und vorzugsweise parallel zu der Hauptstromflussrichtung zu messen, und

b) **dass** der erste Spannungsmesskontakt (9) an dem ersten Anschlussteil (2) zusammen mit dem dritten Spannungsmesskontakt (12) an dem zweiten Anschlussteil (3) einen zweiten Messkanal (18) bildet, um einen zweiten Spannungsabfall (U13) über dem Widerstandselement (6) und schräg zu der Hauptstromflussrichtung zu messen.

3. Strommesswiderstand (1) nach Anspruch 2, **dadurch gekennzeichnet, dass** der zweite Spannungsmesskontakt (11) an dem zweiten Anschlussteil (3) zusammen mit dem dritten Spannungsmesskontakt (12) an dem zweiten Anschlussteil (3) einen dritten Messkanal (19) bildet, um einen dritten Spannungsabfall (U23) quer zu der Hauptstromflussrichtung zu messen, insbesondere rechtwinklig zu der Hauptstromflussrichtung.

4. Strommesswiderstand (1) nach Anspruch 1, **dadurch gekennzeichnet,**

a) **dass** der zweite Spannungsmesskontakt (11) an dem zweiten Anschlussteil (3) zusammen mit dem dritten Spannungsmesskontakt (12) an dem zweiten Anschlussteil (3) einen ersten Messkanal bildet, um einen ersten Spannungsabfall (U23) quer zu der Hauptstromflussrichtung zu messen, insbesondere rechtwinklig zu der Hauptstromflussrichtung, und

b) **dass** der erste Spannungsmesskontakt (9) an dem ersten Anschlussteil (2) zusammen mit dem dritten Spannungsmesskontakt (12) an dem zweiten Anschlussteil (3) einen zweiten Messkanal bildet, um einen zweiten Spannungsabfall (U13) über dem Widerstandselement (6) schräg zu der Hauptstromflussrichtung zu messen.

5. Strommesswiderstand (1) nach Anspruch 4, **dadurch gekennzeichnet, dass** der erste Spannungsmesskontakt (9) an dem ersten Anschlussteil (2) zusammen mit dem zweiten Spannungsmesskontakt (11) an dem zweiten Anschlussteil (3) einen dritten Messkanal bildet, um einen dritten Spannungsabfall (U12) über dem Widerstandselement (6) und vorzugsweise parallel zu der Hauptstromflussrichtung zu messen zu messen.

6. Strommesswiderstand (1) nach einem der vorhergehenden Ansprüche, **dadurch gekennzeichnet,**

a) **dass** an dem zweiten Anschlussteil (3) ein vierter Spannungsmesskontakt (10) angeordnet ist, der elektrisch leitend mit dem dritten Spannungsmesskontakt (12) verbunden ist, um die Spannung gemeinsam an dem dritten Spannungsmesskontakt (12) und an dem vierten Spannungsmesskontakt (10) zu messen, und/oder

b) **dass** an dem ersten Anschlussteil (2) ein fünfter Spannungsmesskontakt (22, 23) angeordnet ist, der elektrisch leitend mit dem ersten Spannungsmesskontakt (9) verbunden ist, um die Spannung gemeinsam an dem ersten Spannungsmesskontakt (9) und an dem fünften Spannungsmesskontakt (22, 23) zu messen.

7. Strommesswiderstand (1) nach einem der vorhergehenden Ansprüche,
**dadurch gekennzeichnet,**

a) **dass** der erste Spannungsmesskontakt (9) in dem ersten Anschlussteil (2) bezüglich der Seitenränder des Strommesswiderstands (1) mittig angeordnet ist, insbesondere mit einer Exzentrizität, die kleiner ist als 50%, 40%, 30%, 20%, 10% oder 5% der Breite des Strommesswiderstands (1), und/oder
b) **dass** der zweite Spannungsmesskontakt (11) und der umgebende erste Einschnitt (13) in dem zweiten Anschlussteil (3) bezüglich der Seitenränder des Strommesswiderstands (1) mittig angeordnet sind, insbesondere mit einer Exzentrizität, die kleiner ist als 50%, 40%, 30%, 20%, 10% oder 5% der Breite des Strommesswiderstands (1), und/oder
c) **dass** der dritte Spannungsmesskontakt (12) in dem zweiten Anschlussteil (3) außermittig angeordnet ist, und/oder
d) **dass** der erste Spannungsmesskontakt (9) in dem ersten Anschlussteil (2) und der zweite Spannungsmesskontakt (11) in dem zweiten Anschlussteil (3) im Wesentlichen den gleichen Abstand zu den Seitenrändern des Strommesswiderstands (1) aufweisen, so dass das erste Spannungsabfall (U12) über dem Widerstandselement (6) parallel zu der Hauptstromflussrichtung gemessen wird, und/oder
e) **dass** in dem zweiten Anschlussteil (3) der dritte Spannungsmesskontakt (12) und der vierte Spannungsmesskontakt im Wesentlichen den gleichen Abstand zur Mittelachse des Strommesswiderstands (1) haben.

8. Strommesswiderstand (1) nach einem der vorhergehenden Ansprüche, **dadurch gekennzeichnet, dass** in dem zweiten Anschlussteil (3) der zweite Spannungsmesskontakt (11) zwischen dem dritten Spannungsmesskontakt (12) und dem vierten Spannungsmesskontakt angeordnet ist.

9. Strommesswiderstand (1) nach einem der vorhergehenden Ansprüche, **dadurch gekennzeichnet, dass** der erste Einschnitt (13) in dem zweiten Anschlussteil (3) bogenförmig ist, insbesondere U-förmig oder V-förmig, mit einer Basis quer zu der Hauptstromflussrichtung und Schenkeln (15, 16), die im Wesentlichen parallel zu der Hauptstromflussrichtung dem Widerstandselement (6) zugewandt sind.

10. Strommesswiderstand (1) nach Anspruch 9, **dadurch gekennzeichnet,**

a) **dass** die Schenkel (15, 16) des ersten Einschnitts in der Hauptstromflussrichtung bis in das Widerstandselement (6) hineinragen und in dem Widerstandselement (6) enden, wobei die Schenkel (15, 16) des ersten Einschnitts optional unterschiedlich weit oder gleich weit in das Widerstandselement (6) hineinragen, insbesondere mit einer Schenkellänge (dx) innerhalb des Widerstandselements (6) von

a1) höchstens 3mm, 2mm, 1,5mm oder 1mm, und/oder
a2) mindestens 0,1mm, 0,2mm, 0,5mm oder 1mm,

b) **dass** die Schenkel (15, 16) des ersten Einschnitts in der Hauptstromflussrichtung vor dem Widerstandselement (6) in dem zweiten Anschlussteil (3) enden, insbesondere mit einem Abstand zu dem Widerstandselement (6) von

b1) höchstens 3mm, 2mm, 1,5mm oder 1mm, und/oder
b2) mindestens 0,1mm, 0,2mm, 0,5mm oder 1mm.

c) **dass** die Schenkel (15, 16) des ersten Einschnitts in Hauptstromflussrichtung an der Grenze zwischen dem Widerstandselement (6) und dem zweiten Anschlussteil (3) enden.

11. Strommesswiderstand (1) nach einem der vorhergehenden Ansprüche,
**dadurch gekennzeichnet,**

a) **dass** in dem zweiten Anschlussteil (3) der zweite Spannungsmesskontakt (11) und der umgebende erste Einschnitt (13) außermittig angeordnet ist, und/oder
b) **dass** in dem zweiten Anschlussteil (3) der erste Einschnitt (13) von einer Seitenkante des Strommesswiderstands (1) ausgeht und sich bogenförmig oder L-förmig bis in das Widerstandselement (6) hinein erstreckt oder zumindest bis zu der Grenze zwischen dem zweiten Anschlussteil (3) und dem Widerstandselement (6).

12. Strommesswiderstand (1) nach einem der vorhergehenden Ansprüche,
**gekennzeichnet durch**

a) einen zweiten Einschnitt (24) in dem zweiten Anschlussteil (3) zur Beeinflussung des Temperaturverhaltens des Widerstandswerts, wobei der zweite Einschnitt (24) in dem zweiten Anschlussteil (3) einen Stromfluss quer über den zweiten Einschnitt (24) verhindert, und

b) einen dritten Einschnitt (25) in dem ersten Anschlussteil (2) zur Beeinflussung des Temperaturverhaltens des Widerstandswerts, wobei der dritte Einschnitt (25) in dem ersten Anschlussteil (2) einen Stromfluss quer über den dritten Einschnitt (25) verhindert, und

c) optional einen vierten Einschnitt (27) in dem ersten Anschlussteil (2) zur Erzeugung einer weiteren Spannungsmasche und/oder zur Beeinflussung des Temperaturverhaltens des Widerstandswerts, wobei der vierte Einschnitt (27) in dem ersten Anschlussteil (2) einen Stromfluss quer über den vierten Einschnitt (27) verhindert.

13. Strommesswiderstand (1) nach Anspruch 12, **dadurch gekennzeichnet,**

a) **dass** der zweite Einschnitt (24) von einem seitlichen Rand des zweiten Anschlussteils (3) gegenüber dem ersten Einschnitt (13) ausgeht,

b) **dass** der dritte Spannungsmesskontakt (12) in dem zweiten Anschlussteil (3) an demselben seitlichen Rand des zweiten Anschlussteils (3) angeordnet ist wie der zweite Einschnitt (24),

c) **dass** der dritte Spannungsmesskontakt (12) in dem zweiten Anschlussteil (3) zwischen dem Widerstandselement (6) und dem zweiten Einschnitt (24) angeordnet ist,

d) **dass** der dritte Einschnitt (25) vom seitlichen Rand des ersten Anschlussteils (2) auf derselben Seite wie der erste Einschnitt (13) ausgeht,

e) **dass** der erste Spannungsmesskontakt (9) in dem ersten Anschlussteil (3) an demselben seitlichen Rand des ersten Anschlussteils (2) angeordnet ist wie der zweite Einschnitt (25),

f) **dass** der erste Spannungsmesskontakt (9) in dem ersten Anschlussteil (3) zwischen dem Widerstandselement (6) und dem dritten Einschnitt (25) angeordnet ist,

g) **dass** der optionale vierte Einschnitt (27) in dem ersten Anschlussteil (2) vom seitlichen Rand des ersten Anschlussteils (2) gegenüber dem dritten Einschnitt (25) ausgeht, und/oder

h) **dass** optional an dem ersten Anschlussteil (2) ein vierter Spannungsmesskontakt (26) vorgesehen ist, wobei der vierte Spannungsmesskontakt (26) zwischen dem vierten Einschnitt (27) und dem Widerstandselement (6) angeordnet ist.

14. Strommesswiderstand (1) nach Anspruch 12 oder 13, **dadurch gekennzeichnet,**

a) **dass** der zweite Einschnitt (24) L-förmig oder bogenförmig ist oder gerade und optional quer zur Hauptstromflussrichtung verläuft, und/oder

b) **dass** der dritte Einschnitt (25) L-förmig oder bogenförmig ist oder gerade und optional quer zur Hauptstromflussrichtung verläuft, und/oder

c) **dass** der vierte Einschnitt (27) L-förmig oder bogenförmig ist oder gerade und quer zur Hauptstromflussrichtung verläuft, und/oder

d) **dass** sich der zweite Einschnitt (24) in dem zweiten Anschlussteil (3) bis an oder in das Widerstandselement (6) erstreckt oder in dem zweiten Anschlussteil (3) vor dem Widerstandselement (6) endet, und/oder

e) **dass** sich der dritte Einschnitt (25) in dem ersten Anschlussteil (2) bis an oder in das Widerstandselement (6) erstreckt oder in dem ersten Anschlussteil (2) vor dem Widerstandselement (6) endet, und/oder

f) **dass** sich der vierte Einschnitt (27) in dem ersten Anschlussteil (2) bis an oder in das Widerstandselement (6) erstreckt oder in dem ersten Anschlussteil (2) vor dem Widerstandselement (6) endet.

15. Strommesswiderstand (1) nach einem der Ansprüche 12 bis 14, **dadurch gekennzeichnet,**

a) **dass** der zweite Einschnitt (24) im Wesentlichen die gleiche Länge hat wie der dritte Einschnitt (25), oder

b) **dass** der zweite Einschnitt (25) eine andere Länge hat als der dritte Einschnitt (24).

16. Strommesswiderstand (1) nach einem der Ansprüche 12 bis 15, **dadurch gekennzeichnet,**

a) **dass** der erste Einschnitt (13) im Wesentlichen die gleiche Länge hat wie der vierte Einschnitt (27), oder

b) **dass** der erste Einschnitt (13) eine andere Länge hat als der vierte Einschnitt (27).

17. Strommesswiderstand (1) nach einem der vorhergehenden Ansprüche,
**dadurch gekennzeichnet,**

a) **dass** das Leitermaterial der Anschlussteile (2, 3) Kupfer, eine Kupferlegierung, Aluminium oder eine Aluminiumlegierung ist, und/oder

b) **dass** das Leitermaterial der Anschlussteile (2, 3) einen kleineren spezifischen elektrischen Widerstand aufweist als das Widerstandsmaterial des Widerstandselements (6), und/oder

c) **dass** das Widerstandsmaterial des Widerstandselements (6) eine der folgenden Legierungen ist:

c1) eine Kupfer-Legierung, insbesondere eine Kupfer-Mangan-Zinn-Legierung, insbesondere CuMn12Ni2 oder CuMn7Sn2,3, oder eine Kupfer-Mangan-Nickel-Legierung, insbesondere Cu84Ni4Mn12 oder Cu65Mn25Ni10, oder eine Kupfer-Chrom-Legierung,

c2) eine Nickellegierung, insbesondere NiCr oder CuNi, und/oder

d) **dass** das Widerstandselement (6) elektrisch und mechanisch mit den beiden Anschlussteilen (2, 3) verbunden ist, insbesondere durch eine Schweißverbindung, insbesondere durch eine Elektronenstrahlverschweißung, und/oder

e) **dass** das Widerstandsmaterial einen spezifischen elektrischen Widerstand aufweist, der kleiner ist als $2 \cdot 10^{-4}\,\Omega \cdot m$, $2 \cdot 10^{-5}\,\Omega \cdot m$ oder $2 \cdot 10^{-6}\,\Omega \cdot m$, und/oder

f) **dass** das Widerstandsmaterial einen spezifischen elektrischen Widerstand aufweist, der größer ist als $2 \cdot 10^{-6}\,\Omega \cdot m$, $2 \cdot 10^{-7}\,\Omega \cdot m$, und/oder

g) **dass** das Leitermaterial einen spezifischen elektrischen Widerstand aufweist, der kleiner ist als $10^{-6}\,\Omega \cdot m$ oder $10^{-7}\,\Omega \cdot m$, und/oder

h) **dass** der Strommesswiderstand (1) niederohmig ist mit einem Widerstandswert von höchstens als $1\,\mu\Omega$, $10\,\mu\Omega$, $20\,\mu\Omega$, $33\,\mu\Omega$, $50\,\mu\Omega$, $100\,\mu\Omega$, $500\,\mu\Omega$, $10\,m\Omega$, $5\,m\Omega$, $2\,m\Omega$ oder $1\,m\Omega$, und/oder

i) **dass** der Strommesswiderstand (1) eine Strombelastbarkeit von mindestens 1A, 10A, 100A, 1kA oder 5 kA aufweist, und/oder

j) **dass** das Widerstandselement (6) plattenförmig ist, insbesondere als ebene Platte, und/oder

k) **dass** die Anschlussteile (2, 3) jeweils plattenförmig sind, insbesondere als ebene Platte, und/oder

l) **dass** der Strommesswiderstand (1) in der Hauptstromflussrichtung eine Länge aufweist, die kleiner ist als 30cm, 20cm oder 10cm, und/oder

m) **dass** der Strommesswiderstand (1) rechtwinklig der Hauptstromflussrichtung eine Breite aufweist, die kleiner ist als 20cm, 10cm oder 5cm, und/oder

n) **dass** der Strommesswiderstand (1) eine Dicke aufweist, die kleiner ist als 10 mm, 5 mm, 4 mm, 2 mm oder 1 mm, und/oder

o) **dass** die beiden Anschlussteile (2, 3) jeweils mindestens einen Stromanschluss (4, 5) aufweisen, um den Strom (I) einzuleiten bzw. auszuleiten, wobei die einzelnen Stromanschlüsse vorzugsweise jeweils mindestens eine Bohrung (4, 5) in dem jeweiligen Anschlussteil aufweisen, und/oder

p) **dass** die einzelnen Spannungsmesskontakte jeweils Kontaktinseln sind, die aus einer elektrisch leitfähigen Beschichtung auf dem jeweiligen Anschlussteil bestehen, und/oder

q) **dass** die einzelnen Kontaktinseln jeweils im Wesentlichen rechteckig sind, und/oder

r) **dass** die Beschichtung der Kontaktinseln aus einem anderen Leitermaterial besteht als die Anschlussteile (2, 3), und/oder

s) **dass** in das Widerstandselement (6) einseitig oder beidseitig ein Trimmschnitt eingebracht ist, um den Widerstandswert des Strommesswiderstands (1) und/oder den Temperaturkoeffizienten des Widerstandswerts des Strommesswiderstands (1) einzustellen,

t) **dass** der Strommesswiderstand (1) optional Spannungsmesskontakte für genau zwei oder genau drei Messkanäle hat,

u) **dass** optional drei Spannungsmesskontakte (9, 11, 12) vorgesehen sind, die einen Dreipunktabgriff an einer geschlossenen Masche an dem ersten Anschlussteil (2) einerseits und an dem zweiten Anschlussteil (3) andererseits bilden, wobei der Dreipunktabgriff drei Messkanäle (17-19) bereitstellt, die drei Spannungsmesswerte (U12, U13, U23) liefern, um eine Fehlerdiagnose zu ermöglichen.

18. Strommesseinrichtung mit

a) einem Strommesswiderstand (1) nach einem der vorhergehenden Ansprüche und

b) einer Spannungsmesseinrichtung (20) zur getrennten Spannungsmessung in dem ersten Messkanal (17) und in dem zweiten Messkanal (18) und optional zusätzlich in dem dritten Messkanal (19), und

c) einer Auswertungseinheit (21)

c1) zur Ermittlung des durch den Strommesswiderstand (1) fließenden Stroms (I) aus den Spannungsmesswerten (U12, U13, U23) in den verschiedenen Messkanälen (17-19), und/oder

c2) zur Diagnose eines Messfehlers durch eine Auswertung der Spannungsmesswerte (U12, U13, U23) in den verschiedenen Messkanälen (17-19).

19. Strommesseinrichtung nach Anspruch 18, **dadurch gekennzeichnet,**

a) **dass** die Spannungsmesseinrichtung (20) folgende Spannungen misst:

U12: Spannung zwischen dem ersten Spannungsmesskontakt (9) an dem ersten Anschlussteil (2) und dem zweiten Spannungsmesskontakt (11) an dem zweiten Anschlussteil (3),

U23: Spannung zwischen dem zweiten Spannungsmesskontakt (11) an dem zweiten Anschlussteil (3) und dem dritten Spannungsmesskontakt (12) an dem zweiten Anschlussteil (3),

U13: Spannung zwischen dem ersten Spannungsmesskontakt (9) an dem ersten Anschlussteil (2) und dem dritten Spannungsmesskontakt (12) an dem zweiten Anschlussteil (3),

b) **dass** die Auswertungseinheit (21) aus den Spannungen U12, U23 und U13 folgende Abweichung $\Delta U$ berechnet:

$$\Delta U = U12 + U23 - U13,$$

und
c) **dass** die Auswertungseinheit ein Fehlersignal erzeugt, wenn die Abweichung $\Delta U$ einen zulässigen Maximalwert übersteigt.

20. Strommessverfahren zum Messen eines elektrischen Stroms mittels eines Strommesswiderstands (1) nach einem der Ansprüche 1 bis 17, mit den folgenden Schritten:

a) Durchleiten des zu messenden elektrischen Stroms (I) durch den Strommesswiderstand (1),
b) Messen folgender Spannungen an dem Strommesswiderstand (1), während der zu messende Strom (I) durch den Strommesswiderstand (1) fließt:

U12: Spannung zwischen dem ersten Spannungsmesskontakt (9) an dem ersten Anschlussteil (2) und dem zweiten Spannungsmesskontakt (11) an dem zweiten Anschlussteil (3),
U23: Spannung zwischen dem zweiten Spannungsmesskontakt (11) an dem zweiten Anschlussteil (3) und dem dritten Spannungsmesskontakt (12) an dem zweiten Anschlussteil (3),
U13: Spannung zwischen dem ersten Spannungsmesskontakt (9) an dem ersten Anschlussteil (2) und dem dritten Spannungsmesskontakt (12) an dem zweiten Anschlussteil (3),

c) Berechnen des Stroms (I) in Abhängigkeit von mindestens einer der gemessenen Spannungen U12, U13, U23.

21. Strommessverfahren nach Anspruch 20, **gekennzeichnet durch** folgende Schritte für eine Fehlerdiagnose:

a) Berechnen einer Abweichung $\Delta U$ aus den Spannungen U12, U23 und U13 nach folgender Formel:

$$\Delta U = U12 + U23 - U13,$$

und
b) Erzeugen eines Fehlersignals, wenn die Abweichung $\Delta U$ einen Maximalwert übersteigt.

22. Strommessverfahren zum Messen eines elektrischen Stroms mittels eines Strommesswiderstands (1) nach einem der Ansprüche 1 bis 17, mit den folgenden Schritten:

a) Durchleiten des zu messenden elektrischen Stroms (I) durch den Strommesswiderstand (1),
b) Messen folgender Spannungen an dem Strommesswiderstand (1), während der zu messende Strom (I) durch den Strommesswiderstand (1) fließt:

U34: Spannung zwischen dem dritten Spannungsmesskontakt (12) an dem zweiten Anschlussteil (3) und dem vierten Spannungsmesskontakt (26) an dem ersten Anschlussteil (2),
U41: Spannung zwischen dem vierten Spannungsmesskontakt (26) an dem ersten Anschlussteil (2) und dem ersten Spannungsmesskontakt (9) an dem ersten Anschlussteil (2),
U31: Spannung zwischen dem dritten Spannungsmesskontakt (12) an dem zweiten Anschlussteil (3) und dem ersten Spannungsmesskontakt (9) an dem ersten Anschlussteil (2),

c) Berechnen des Stroms (I) in Abhängigkeit von mindestens einer der gemessenen Spannungen U34, U41, U31.

23. Strommessverfahren nach Anspruch 22, **gekennzeichnet durch** folgende Schritte für eine Fehlerdiagnose:

a) Berechnen einer Abweichung $\Delta U$ aus den Spannungen U34, U41, U31 nach folgender Formel:

$$\Delta U = U34 + U41 - U31,$$

und
b) Erzeugen eines Fehlersignals, wenn die Abweichung $\Delta U$ einen Maximalwert übersteigt.

**Claims**

1. Current-sensing resistor (1) for measuring an electric current (I), having

a) a first connection part (2) made of an electrically conductive conductor material, in particular for introducing the electric current (I) to be measured into the current-sensing resistor (1),
b) a second connection part (3) made of an electrically conductive conductor material, in particular for carrying away the electrical current (I) to be measured from the current-sensing resistor (1),
c) a resistor element (6) made of a resistor material, the resistor element (6) being arranged in a main current flow direction between the first connection part (2) and the second connection part (3), so that the current (I) to be measured flows through the resistor element (6),
d) a first voltage measurement contact (9) at the first connection part (2) for measuring the voltage at the first connection part (2),
e) a second voltage measurement contact (11) at the second connection part (3) for voltage measurement at the second connection part (3), and
f) a first cut (13) in the second connection part (3), the first cut (13) surrounding the second voltage measurement contact (11) and preventing current flow across the first cut (13), **characterized in**
g) **that** a third voltage measurement contact (12) is arranged at the second connection part (3) for measuring the voltage at the second connection part (3), and
h) **that** the third voltage measurement contact (12) at the second connection part (3) is arranged offset with respect to the main current flow direction transversely to the second voltage measurement contact (11) at the second connection part (3).

2. Current-sensing resistor (1) according to claim 1, **characterized in,**

a) **that** the first voltage measurement contact (9) at the first connection part (2) together with the second voltage measurement contact (11) at the second connection part (3) forms a first measurement channel (17) for measuring a first voltage drop (U12) across the resistor element (6) and preferably parallel to the main current flow direction, and
b) **that** the first voltage measurement contact (9) at the first connection part (2) together with the third voltage measurement contact (12) at the second connection part (3) forms a second measurement channel (18) in order to measure a second voltage drop (U13) across the resistor element (6) and obliquely to the main current flow direction.

3. Current-sensing resistor (1) according to claim 2, **characterized in that** the second voltage measurement contact (11) at the second connection part (3) together with the third voltage measurement contact (12) at the second connection part (3) forms a third measurement channel (19) for measuring a third voltage drop (U23) transversely to the main current flow direction, in particular at right angles to the main current flow direction.

4. Current-sensing resistor (1) according to claim 1, **characterized in**

a) **that** the second voltage measurement contact (11) at the second connection part (3) together with the third voltage measurement contact (12) at the second connection part (3) forms a first measurement channel for measuring a first voltage drop (U23) transversely to the main current flow direction, in particular at right angles to the main current flow direction, and
b) **that** the first voltage measurement contact (9) at the first connection part (2) together with the third voltage measurement contact (12) at the second connection part (3) forms a second measurement channel in order to measure a second voltage drop (U13) across the resistor element (6) obliquely to the main current flow direction.

5. Current-sensing resistor (1) according to claim 4, **characterized in that** the first voltage measurement contact (9) at the first connection part (2) together with the second voltage measurement contact (11) at the second connection part (3) forms a third measurement channel in order to measure a third voltage drop (U12) across the resistor element (6) and preferably parallel to the main current flow direction.

6. Current-sensing resistor (1) according to one of the preceding claims, **characterized in**

a) **that** a fourth voltage measurement contact (10) is arranged at the second connection part (3), which is electrically conductively connected to the third voltage measurement contact (12) in order to measure the voltage jointly at the third voltage measurement contact (12) and at the fourth voltage measurement contact (10), and/or
b) a fifth voltage measurement contact (22, 23) is arranged at the first connection part (2) and is electrically conductively connected to the first voltage measurement contact (9) in order to measure the voltage jointly at the first voltage measurement contact (9) and at the fifth voltage measurement contact (22, 23).

7. Current-sensing resistor (1) according to one of the preceding claims, **characterized in**

a) **that** the first voltage measurement contact (9) is arranged centrally in the first connection part (2) with respect to the side edges of the current-sensing resistor (1), in particular with an eccentricity which is smaller than 50%, 40%, 30%, 20%, 10% or 5% of the width of the current-sensing resistor (1), and/or
b) **that** the second voltage measurement contact (11) and the surrounding first cut (13) in the second connection part (3) are arranged centrally with respect to the side edges of the current-sensing resistor (1), in particular with an eccentricity which is smaller than 50%, 40%, 30%, 20%, 10% or 5% of the width of the current-sensing resistor (1), and/or
c) **that** the third voltage measurement contact (12) is arranged off-centre in the second connection part (3), and/or
d) **that** the first voltage measurement contact (9) in the first connection part (2) and the second voltage measurement contact (11) in the second connection part (3) are at substantially the same distance from the side edges of the current-sensing resistor (1), so that the first voltage drop (U12) across the resistor element (6) is measured parallel to the main current flow direction, and/or
e) **that** in the second connection part (3) the third voltage measurement contact (12) and the fourth voltage measurement contact have substantially the same distance to the centre axis of the current-sensing resistor (1).

8. Current-sensing resistor (1) according to one of the preceding claims, **characterized in that** in the second connection part (3) the second voltage measurement contact (11) is arranged between the third voltage measurement contact (12) and the fourth voltage measurement contact.

9. Current-sensing resistor (1) according to one of the preceding claims, **characterized in that** the first cut (13) in the second connection part (3) is arc-shaped, in particular U-shaped or V-shaped, with a base transverse to the main current flow direction and legs (15, 16) which face the resistor element (6) essentially parallel to the main current flow direction.

10. Current-sensing resistor (1) according to claim 9, **characterized in,**

a) **that** the legs (15, 16) of the first cut project into the resistor element (6) in the main current flow direction and end in the resistor element (6), the legs (15, 16) of the first cut optionally projecting into the resistor element (6) to a different extent or to the same extent, in particular with a leg length (dx) within the resistor element (6) of

a1) at most 3mm, 2mm, 1.5mm or 1mm, and/or
a2) at least 0.1mm, 0.2mm, 0.5mm or 1mm,

b) **that** the legs (15, 16) of the first cut end in the second connection part (3) before the resistor element (6) in the main current flow direction, in particular at a distance from the resistor element (6) of

b1) at most 3mm, 2mm, 1.5mm or 1mm, and/or
b2) at least 0.1mm, 0.2mm, 0.5mm or 1mm.

c) **that** the legs (15, 16) of the first cut in the main current flow direction end at the boundary between the resistor element (6) and the second connection part (3).

11. Current-sensing resistor (1) according to one of the preceding claims, **characterized in**

a) **that** in the second connection part (3) the second voltage measurement contact (11) and the surrounding first cut (13) are arranged off-centre, and/or
b) **that**, in the second connection part (3), the first cut (13) starts from a side edge of the current-sensing resistor (1) and extends in an arcuate or L-shaped manner into the resistor element (6) or at least up to the boundary between the second connection part (3) and the resistor element (6).

12. Current-sensing resistor (1) according to one of the preceding claims, **characterized by**

a) a second cut (24) in the second connection part (3) for influencing the temperature behaviour of the resistance value, the second cut (24) in the second connection part (3) preventing a current flow across the second cut (24), and
b) a third cut (25) in the first connection part (2) for influencing the temperature behaviour of the resistance value, wherein the third cut (25) in the first connection part (2) prevents current flow across the third cut (25), and
c) optionally a fourth cut (27) in the first connection part (2) for generating a further voltage loop and/or for influencing the temperature behaviour of the resistance value, wherein the fourth cut (27) in the first connection part (2) prevents current flow across the fourth cut (27).

13. Current-sensing resistor (1) according to claim 12, **characterized in,**

a) **that** the second cut (24) extends from a lateral edge of the second connection part (3) opposite the first cut (13),
b) **that** the third voltage measurement contact (12) is arranged in the second connection part (3) at the same lateral edge of the second connection part (3) as the second cut (24),
c) **that** the third voltage measurement contact (12) is arranged in the second connection part (3) between the resistor element (6) and the second cut (24),
d) **that** the third cut (25) extends from the lateral edge of the first connection part (2) on the same side as the first cut (13),
e) **that** the first voltage measurement contact (9) is arranged in the first connection part (3) at the same lateral edge of the first connection part (2) as the second cut (25),
f) **that** the first voltage measurement contact (9) is arranged in the first connection part (3) between the resistor element (6) and the third cut (25),
g) **that** the optional fourth cut (27) in the first connection part (2) starts from the lateral edge of the first connection part (2) opposite the third cut (25), and/or
h) **that** a fourth voltage measurement contact (26) is optionally provided at the first connection part (2), wherein the fourth voltage measurement contact (26) is arranged between the fourth cut (27) and the resistor element (6).

14. Current-sensing resistor (1) according to claim 12 or 13, **characterized in,**

a) **that** the second cut (24) is L-shaped or arcuate or runs straight and optionally transversely to the main current flow direction, and/or
b) **that** the third cut (25) is L-shaped or curved or straight and optionally runs transversely to the main flow direction, and/or
c) **that** the fourth cut (27) is L-shaped or arcuate or straight and runs transversely to the main flow direction, and/or
d) **that** the second cut (24) in the second connection part (3) extends up to or into the resistor element (6) or ends in the second connection part (3) before the resistor element (6), and/or
e) **that** the third cut (25) in the first connection part (2) extends to or into the resistor element (6) or ends in the first connection part (2) before the resistor element (6), and/or

f) **that** the fourth cut (27) in the first connection part (2) extends to or into the resistor element (6) or ends in the first connection part (2) before the resistor element (6).

15. Current-sensing resistor (1) according to any one of claims 12 to 14, **characterized in,**

a) **that** the second cut (24) has substantially the same length as the third cut (25), or
b) **that** the second cut (25) has a different length than the third cut (24).

16. Current-sensing resistor (1) according to any one of claims 12 to 15, **characterized in,**

a) **that** the first cut (13) has substantially the same length as the fourth cut (27), or
b) **that** the first cut (13) has a different length than the fourth cut (27).

17. Current-sensing resistor (1) according to one of the preceding claims, **characterized in**

a) **that** the conductor material of the connection parts (2, 3) is copper, a copper alloy, aluminium or an aluminium alloy, and/or
b) **that** the conductor material of the connection parts (2, 3) has a smaller specific electrical resistance than the resistor material of the resistor element (6), and/or
c) **that** the resistor material of the resistor element (6) is one of the following alloys:

c1) a copper alloy, in particular a copper-manganese-tin alloy, in particular CuMn12Ni2 or CuMn7Sn2,3, or a copper-manganese-nickel alloy, in particular Cu84Ni4Mn12 or Cu65Mn25Ni10, or a copper-chromium alloy,
c2) a nickel alloy, in particular NiCr or CuNi, and/or

d) **that** the resistor element (6) is electrically and mechanically connected to the two connecting elements (2, 3), in particular by a welded connection, in particular by electron beam welding, and/or
e) **that** the resistor material has a specific electrical resistance which is less than $2 \cdot 10^{-4}$ $\Omega \cdot m$, $2 \cdot 10^{-5}$ $\Omega \cdot m$ or $2 \cdot 10^{-6}$ $\Omega \cdot m$, and/or
f) **that** the resistor material has a specific electrical resistance greater than $2 \cdot 10^{-6}$ $\Omega \cdot m$, $2 \cdot 10^{-7}$ $\Omega \cdot m$, and/or
g) **that** the conductor material has a specific electrical resistance which is smaller than $10^{-6}$ $\Omega \cdot m$ or $10^{-7}$ $\Omega \cdot m$, and/or
h) **that** the current-sensing resistor (1) is of low resistance with a resistance value of at most 1 $\mu\Omega$, 10 $\mu\Omega$, 20 $\mu\Omega$, 33 $\mu\Omega$, 50 $\mu\Omega$, 100 $\mu\Omega$, 500 $\mu\Omega$, 10 m$\Omega$, 5 m$\Omega$, 2 m$\Omega$ or 1 m$\Omega$, and/or

i) **that** the current-sensing resistor (1) has a current carrying capacity of at least 1A, 10A, 100A, 1kA or 5 kA, and/or

j) **that** the resistor element (6) is plate-shaped, in particular as a flat plate, and/or

k) **that** the connection parts (2, 3) are each plate-shaped, in particular as a flat plate, and/or

l) **that** the current-sensing resistor (1) has a length in the main current flow direction which is smaller than 30cm, 20cm or 10cm, and/or

m) **that** the current-sensing resistor (1) has a width at right angles to the main current flow direction which is smaller than 20cm, 10cm or 5cm, and/or

n) **that** the current-sensing resistor (1) has a thickness which is smaller than 10 mm, 5 mm, 4 mm, 2 mm or 1 mm, and/or

o) in that the two connection parts (2, 3) each have at least one current connection (4, 5) for introducing and discharging the current (I), the individual current connections preferably each having at least one hole (4, 5) in the respective connection part, and/or

p) in that the individual voltage measurement contacts are in each case contact pads which consist of an electrically conductive coating at the respective connection part, and/or

q) in that the individual contact pads are each essentially rectangular, and/or

r) **that** the coating of the contact pads consists of a different conductor material than the connection parts (2, 3), and/or

s) **that** a trim cut is made in the resistor element (6) on one or both sides in order to adjust the resistance value of the current-sensing resistor (1) and/or the temperature coefficient of the resistance value of the current-sensing resistor (1),

t) **that** the current-sensing resistor (1) optionally has voltage measurement contacts for exactly two or exactly three measurement channels,

u) **that** optionally three voltage measurement contacts (9, 11, 12) are provided which form a three-point tap on a closed loop at the first connection part (2) on the one hand and at the second connection part (3) on the other hand, the three-point tap providing three measurement channels (17-19) which supply three voltage measurement values (U12, U13, U23) in order to enable fault diagnosis.

18. Current measuring device with

a) a current-sensing resistor (1) according to one of the preceding claims and

b) a voltage measuring device (20) for separate voltage measurement in the first measurement channel (17) and in the second measurement channel (18) and optionally additionally in the third measurement channel (19), and

c) an evaluation unit (21)

c1) for determining the current (I) flowing through the current-sensing resistor (1) from the voltage measurement values (U12, U13, U23) in the various measurement channels (17-19), and/or

c2) for diagnosing a measurement error by evaluating the voltage measurement values (U12, U13, U23) in the various measurement channels (17-19).

19. Current measuring device according to claim 18, **characterized in,**

a) **that** the voltage measuring device (20) measures the following voltages:

U12: Voltage between the first voltage measurement contact (9) at the first connection part (2) and the second voltage measurement contact (11) at the second connection part (3),

U23: Voltage between the second voltage measurement contact (11) at the second connection part (3) and the third voltage measurement contact (12) at the second connection part (3),

U13: Voltage between the first voltage measurement contact (9) at the first connection part (2) and the third voltage measurement contact (12) at the second connection part (3),

b) **that** the evaluation unit (21) calculates the following deviation $\Delta U$ from the voltages U12, U23 and U13:

$$\Delta U = U12 + U23 - U13,$$

and

c) **that** the evaluation unit generates an error signal if the deviation $\Delta U$ exceeds a permissible maximum value.

20. Current measuring method for measuring an electric current by means of a current measuring device (1) according to any one of claims 1 to 17, comprising the following steps:

a) passing the electric current (I) to be measured through the current-sensing resistor (1),

b) measuring the following voltages at the current-sensing resistor (1) while the current (I) to be measured flows through the current-sensing resistor (1):

U12: Voltage between the first voltage measurement contact (9) at the first connection part (2) and the second voltage measurement contact (11) at the second connection part (3),

U23: Voltage between the second voltage measurement contact (11) at the second connection part (3) and the third voltage measurement contact (12) at the second connection part (3),

U13: Voltage between the first voltage measurement contact (9) at the first connection part (2) and the third voltage measurement contact (12) at the second connection part (3),

c) calculating the current (I) as a function of at least one of the measured voltages U12, U13, U23.

21. Current measuring method according to claim 20, **characterized by** the following steps for fault diagnosis:

a) Calculating a deviation ∆U from the voltages U12, U23 and U13 according to the following formula:

$$\Delta U = U12 + U23 - U13,$$

and

b) Generating an error signal if the deviation ∆U exceeds a maximum value.

22. Current measuring method for measuring an electric current by means of a current measuring device (1) according to any one of claims 1 to 17, comprising the following steps:

a) passing the electric current (I) to be measured through the current-sensing resistor (1),

b) measuring the following voltages at the current-sensing resistor (1) while the current (I) to be measured flows through the current-sensing resistor (1):

U34: Voltage between the third voltage measurement contact (12) at the second connection part (3) and the fourth voltage measurement contact (26) at the first connection part (2),

U41: Voltage between the fourth voltage measurement contact (26) at the first connection part (2) and the first voltage measurement contact (9) at the first connection part (2),

U31: Voltage between the third voltage measurement contact (12) at the second connection part (3) and the first voltage measurement contact (9) at the first connection part (2),

c) calculating the current (I) as a function of at least one of the measured voltages U34, U41, U31.

23. Current measuring method according to claim 22, **characterized by** the following steps for fault diagnosis:

a) calculating a deviation ∆U from the voltages U34, U41, U31 according to the following formula:

$$\Delta U = U34 + U41 - U31,$$

and

b) generating a fault signal if the deviation ∆U exceeds a maximum value.

**Revendications**

1. Résistance de mesure de courant (1) pour mesurer un courant électrique (I), comprenant

a) une première partie de connexion (2) en un matériau conducteur électrique, en particulier pour l'introduction du courant électrique à mesurer (I) dans la résistance de mesure de courant (1),

b) une deuxième partie de connexion (3) en un matériau conducteur électrique, en particulier pour évacuer le courant électrique à mesurer (I) de la résistance de mesure de courant (1),

c) un élément résistif (6) en matériau résistif, l'élément résistif (6) étant disposé dans le sens principal de circulation du courant entre la première partie de connexion (2) et la deuxième partie de connexion (3), de sorte que le courant à mesurer (I) circule à travers l'élément résistif (6),

d) un premier contact de mesure de tension (9) sur la première partie de connexion (2) pour la mesure de la tension sur la première partie de connexion (2),

e) un deuxième contact de mesure de tension (11) sur la deuxième partie de connexion (3) pour la mesure de tension sur la deuxième partie de connexion (3), et

f) une première entaille (13) dans la deuxième partie de connexion (3), la première entaille (13) entourant le deuxième contact de mesure de tension (11) et empêchant le passage du courant à travers la première entaille (13), **caractérisé en ce que**

g) qu'un troisième contact de mesure de tension (12) est disposé sur la deuxième partie de connexion (3) pour mesurer la tension sur la deuxième partie de connexion (3), et

h) le troisième contact de mesure de tension (12) est monté sur la deuxième partie de connexion (3) par rapport à la ligne de courant principale.

2. Résistance de mesure de courant (1) selon la revendication 1, **caractérisée en ce que**

a) le premier contact de mesure de tension (9) sur la première partie de connexion (2) forme, avec le deuxième contact de mesure de tension (11) sur la deuxième partie de connexion (3), un premier canal de mesure (17) pour mesurer une première chute de tension (U12) aux bornes de l'élément résistif (6) et, de préférence, parallèlement à la direction principale de circulation du courant, et

b) le premier contact de mesure de tension (9) sur la première partie de connexion (2) forme, avec le troisième contact de mesure de tension (12) sur la deuxième partie de connexion (3), un deuxième canal de mesure (18) pour mesurer une deuxième chute de tension (U13) aux bornes de l'élément résistif (6) et en biais par rapport à la direction principale de circulation du courant.

3. Résistance de mesure de courant (1) selon la revendication 2, **caractérisée en ce que** le deuxième contact de mesure de tension (11) sur la deuxième partie de connexion (3) forme, avec le troisième contact de mesure de tension (12) sur la deuxième partie de connexion (3), un troisième canal de mesure (19) pour mesurer une troisième chute de tension (U23) transversalement à la direction principale de circulation du courant, en particulier perpendiculairement à la direction principale de circulation du courant.

4. Résistance de mesure de courant (1) selon la revendication 1, **caractérisée en ce que,**

a) **en ce que** le deuxième contact de mesure de tension (11) sur la deuxième partie de connexion (3) forme, conjointement avec le troisième contact de mesure de tension (12) sur la deuxième partie de connexion (3), un premier canal de mesure pour mesurer une première chute de tension (U23) transversalement à la direction de circulation du courant principal, en particulier perpendiculairement à la direction de circulation du courant principal, et

b) le premier contact de mesure de tension (9) sur la première partie de connexion (2) forme, avec le troisième contact de mesure de tension (12) sur la deuxième partie de connexion (3), un deuxième canal de mesure pour mesurer une deuxième chute de tension (U13) aux bornes de l'élément résistif (6) obliquement par rapport à la direction principale de circulation du courant.

5. Résistance de mesure de courant (1) selon la revendication 4, **caractérisée en ce que** le premier contact de mesure de tension (9) sur la première partie de connexion (2) forme, avec le deuxième contact de mesure de tension (11) sur la deuxième partie de connexion (3), un troisième canal de mesure pour mesurer une troisième chute de tension (U12) aux bornes de l'élément résistif (6) et, de préférence, parallèlement à la direction principale de circulation du courant.

6. Résistance de mesure de courant (1) selon l'une des revendications précédentes, **caractérisé en ce que,**

a) un quatrième contact de mesure de tension (10) est disposé sur la deuxième partie de connexion (3), lequel est relié de manière électriquement conductrice au troisième contact de mesure de tension (12) afin de mesurer la tension conjointement sur le troisième contact de mesure de tension (12) et sur le quatrième contact de mesure de tension (10), et/ou

b) un cinquième contact de mesure de tension (22, 23) est disposé sur la première partie de connexion (2), lequel est relié de manière électriquement conductrice au premier contact de mesure de tension (9) afin de mesurer la tension en commun sur le premier contact de mesure de tension (9) et sur le cinquième contact de mesure de tension (22, 23).

7. Résistance de mesure de courant (1) selon l'une des revendications précédentes, **caractérisé en ce que**

a) que le premier contact de mesure de tension (9) est disposé dans la première partie de connexion (2) au centre par rapport aux bords latéraux de la résistance de mesure de courant (1), en particulier avec une excentricité qui est inférieure à 50%, 40%, 30%, 20%, 10% ou 5% de la largeur de la résistance de mesure de courant (1), et/ou

b) que le deuxième contact de mesure de tension (11) et la première entaille (13) qui l'entoure sont disposés dans la deuxième partie de connexion (3) au centre par rapport aux bords latéraux de la résistance de mesure de courant (1), en particulier avec une excentricité qui est inférieure à 50%, 40%, 30%, 20%, 10% ou 5% de la largeur de la résistance de mesure de courant (1), et/ou

c) que le troisième contact de mesure de tension (12) est disposé de manière excentrée dans la deuxième partie de connexion (3), et/ou

d) que le premier contact de mesure de tension (9) dans la première partie de connexion (2) et le deuxième contact de mesure de tension (11) dans la deuxième partie de connexion (3) présentent sensiblement la même distance par rapport aux bords latéraux de la résistance de mesure de courant (1), de sorte que la première chute de tension (U12) est mesurée aux bornes de l'élément résistif (6) parallèlement à la direction principale d'écoulement du courant, et/ou

e) dans la deuxième partie de connexion (3), le troisième contact de mesure de tension (12) et le quatrième contact de mesure de tension sont sensiblement à la même distance de l'axe central de la résistance de mesure de courant (1).

**8.** Résistance de mesure de courant (1) selon l'une des revendications précédentes, **caractérisée en ce que,** dans la deuxième partie de connexion (3), le deuxième contact de mesure de tension (11) est disposé entre le troisième contact de mesure de tension (12) et le quatrième contact de mesure de tension.

**9.** Résistance de mesure de courant (1) selon l'une des revendications précédentes, **caractérisée en ce que** la première entaille (13) dans la deuxième partie de connexion (3) est en forme d'arc, en particulier en forme de U ou de V, avec une base transversale à la direction principale d'écoulement du courant et des branches (15, 16) qui sont sensiblement parallèles à la direction principale d'écoulement du courant et tournées vers l'élément résistif (6).

**10.** Résistance de mesure de courant (1) selon la revendication 9, **caractérisée en ce que,**

a) que les branches (15, 16) de la première entaille s'étendent dans la direction principale d'écoulement du courant jusqu'à l'élément résistif (6) et se terminent dans l'élément résistif (6), les branches (15, 16) de la première entaille s'étendant en option sur une distance différente ou sur la même distance dans l'élément résistif (6), en particulier avec une longueur de branche (dx) à l'intérieur de l'élément résistif (6) de

a1) au plus 3mm, 2mm, 1,5mm ou 1mm, et/ou
a2) au moins 0,1mm, 0,2mm, 0,5mm ou 1mm,

b) que les branches (15, 16) de la première entaille se terminent dans le sens principal d'écoulement du courant avant l'élément résistif (6) dans la deuxième partie de connexion (3), en particulier à une distance de l'élément de résistance (6) de

b1) au maximum 3mm, 2mm, 1,5mm ou 1mm, et/ou
b2) au moins 0,1mm, 0,2mm, 0,5mm ou 1mm.

c) que les branches (15, 16) de la première entaille se terminent dans le sens principal de circulation du courant à l'interface entre l'élément résistif (6) et la deuxième partie de connexion (3).

**11.** Résistance de mesure de courant (1) selon l'une des revendications précédentes, **caractérisé en ce que**

a) que dans la deuxième partie de connexion (3), le deuxième contact de mesure de tension (11) et la première entaille (13) qui l'entoure sont disposés de manière excentrée, et/ou

b) dans la deuxième partie de connexion (3), la première entaille (13) part d'un bord latéral de la résistance de mesure de courant (1) et s'étend en forme d'arc ou de L jusque dans l'élément résistif (6) ou au moins jusqu'à la limite entre la deuxième partie de connexion (3) et l'élément résistif (6).

**12.** Résistance de mesure de courant (1) selon l'une des revendications précédentes, **caractérisé par**

a) une deuxième entaille (24) dans la deuxième partie de connexion (3) pour influencer le comportement en température de la valeur de résistance, la deuxième entaille (24) dans la deuxième partie de connexion (3) empêchant un flux de courant transversal sur la deuxième entaille (24), et

b) une troisième entaille (25) dans la première partie de connexion (2) pour influencer le comportement en température de la valeur de résistance, la troisième entaille (25) dans la première partie de connexion (2) empêchant un flux de courant à travers la troisième entaille (25), et

c) en option, une quatrième entaille (27) dans la première partie de connexion (2) pour générer une autre maille de tension et/ou pour influencer le comportement en température de la valeur de résistance, la quatrième entaille (27) dans la première partie de connexion (2) empêchant un flux de courant à travers la quatrième entaille (27).

13. Résistance de mesure de courant (1) selon la revendication 12, **caractérisée en ce que**

a) que la deuxième entaille (24) part d'un bord latéral de la deuxième pièce de connexion (3) opposé à la première entaille (13),

b) le troisième contact de mesure de tension (12) est disposé dans la deuxième pièce de connexion (3) sur le même bord latéral de la deuxième pièce de connexion (3) que la deuxième entaille (24),

c) le troisième contact de mesure de tension (12) est disposé dans la deuxième partie de connexion (3) entre l'élément résistif (6) et la deuxième entaille (24),

d) que la troisième entaille (25) part du bord latéral de la première pièce de connexion (2) du même côté que la première entaille (13),

e) le premier contact de mesure de tension (9) est disposé dans la première partie de connexion (3) sur le même bord latéral de la première partie de connexion (2) que la deuxième entaille (25),

f) que le premier contact de mesure de tension (9) est disposé dans la première partie de connexion (3) entre l'élément résistif (6) et la troisième entaille (25),

g) que la quatrième entaille (27) optionnelle dans la première pièce de connexion (2) part du bord latéral de la première pièce de connexion (2) en face de la troisième entaille (25), et/ou

h) **en ce qu'**un quatrième contact de mesure de tension (26) est prévu en option sur la première pièce de connexion (2), le quatrième contact de mesure de tension (26) étant disposé entre la quatrième entaille (27) et l'élément résistif (6).

14. Résistance de mesure de courant (1) selon la revendication 12 ou 13, **caractérisée en ce que,**

a) que la deuxième entaille (24) est en forme de L ou d'arc ou est droite et s'étend en option transversalement à la direction principale d'écoulement du courant, et/ou

b) que la troisième entaille (25) est en forme de L ou en forme d'arc ou droite et s'étend en option transversalement à la direction principale d'écoulement du courant, et/ou

c) que la quatrième entaille (27) est en forme de L ou d'arc ou est droite et s'étend transversalement à la direction principale d'écoulement du courant, et/ou

d) que la deuxième entaille (24) s'étend dans la deuxième partie de connexion (3) jusqu'à ou dans l'élément résistif (6) ou se termine dans la deuxième partie de connexion (3) avant l'élément de résistance (6), et/ou

e) que la troisième entaille (25) s'étend dans la première partie de connexion (2) jusqu'à ou dans l'élément résistif (6) ou se termine dans la première partie de connexion (2) avant l'élément résistif (6), et/ou

f) que la quatrième entaille (27) s'étend dans la première partie de connexion (2) jusqu'à ou dans l'élément résistif (6) ou se termine dans la première partie de connexion (2) avant l'élément résistif (6).

15. Résistance de mesure de courant (1) selon l'une des revendications 12 à 14, **caractérisée en ce que,**

a) que la deuxième entaille (24) a sensiblement la même longueur que la troisième entaille (25), ou

b) que la deuxième entaille (25) a une longueur différente de celle de la troisième entaille (24).

16. Résistance de mesure de courant (1) selon l'une des revendications 12 à 15, **caractérisée en ce que,**

a) que la première entaille (13) a sensiblement la même longueur que la quatrième entaille (27), ou

b) que la première entaille (13) a une longueur différente de celle de la quatrième entaille (27).

17. Résistance de mesure de courant (1) selon l'une des revendications précédentes, **caractérisé en ce que,**

a) que le matériau conducteur des parties de connexion (2, 3) est du cuivre, un alliage de cuivre, de l'aluminium ou un alliage d'aluminium, et/ou

b) que le matériau conducteur des parties de connexion (2, 3) présente une résistance électrique spécifique inférieure à celle du matériau de résistance de l'élément résistif (6), et/ou

c) le matériau de résistance de l'élément de résistance (6) est l'un des alliages suivants:

c1) un alliage de cuivre, notamment un alliage cuivre-manganèse-étain, en particulier CuMn12Ni2 ou CuMn7Sn2,3, ou un alliage cuivre-manganèse-nickel, notamment Cu84Ni4Mn12 ou Cu65Mn25Ni10, ou un alliage cuivre-chrome,

c2) un alliage de nickel, en particulier NiCr ou CuNi, et/ou

d) que l'élément résistif (6) est relié électriquement et mécaniquement aux deux éléments de connexion (2, 3), en particulier par une liaison soudée, notamment par un soudage par faisceau d'électrons, et/ou

e) que le matériau résistif présente une résistance électrique spécifique qui est inférieure à $2 \cdot 10^{-4}$ $\Omega \cdot$m, $2 \cdot 10^{-5}$ $\Omega \cdot$m ou $2 \cdot 10^{-6}$ $\Omega \cdot$m, et/ou

f) que le matériau résistif présente une résistivité électrique supérieure à $2 \cdot 10^{-6}$ $\Omega \cdot$m, $2 \cdot 10^{-7}$ $\Omega \cdot$m, et/ou

g) que le matériau conducteur présente une résistivité électrique inférieure à $10^{-6}$ $\Omega \cdot$m ou $10^{-7}$ $\Omega \cdot$m, et/ou

h) **en ce que** la résistance de mesure de courant (1) est à basse impédance avec une valeur de résistance inférieure ou égale à 1 $\mu\Omega$, 10 $\mu\Omega$, 20 $\mu\Omega$, 33 $\mu\Omega$, 50 $\mu\Omega$, 100 $\mu\Omega$, 500 $\mu\Omega$, 10 m$\Omega$, 5 m$\Omega$, 2 m$\Omega$ ou 1 m$\Omega$, et/ou

i) que la résistance de mesure de courant (1) présente une capacité de charge de courant d'au moins 1A, 10A, 100A, 1kA ou 5 kA, et/ou

j) que l'élément résistif (6) est en forme de plaque, en particulier de plaque plane, et/ou

k) que les éléments de connexion (2, 3) sont chacun en forme de plaque, en particulier sous forme de plaque plane, et/ou

l) que la résistance de mesure du courant (1) présente, dans le sens principal de circulation du courant, une longueur inférieure à 30 cm, 20 cm ou 10 cm, et/ou

m) que la résistance de mesure du courant (1) présente, à angle droit par rapport à la direction principale de circulation du courant, une largeur qui est inférieure à 20cm, 10cm ou 5cm, et/ou

n) la résistance de mesure du courant (1) a une épaisseur inférieure à 10 mm, 5 mm, 4 mm, 2 mm ou 1 mm, et/ou

o) que les deux parties de connexion (2, 3) présentent chacune au moins un raccordement de courant (4, 5) pour introduire ou évacuer le courant (I), les différents raccordements de courant présentant de préférence chacun au moins un alésage (4, 5) dans la pièce de connexion respective, et/ou

p) que les différents contacts de mesure de tension sont respectivement des îlots de contact qui sont constitués d'un revêtement électriquement conducteur sur la partie de connexion respective, et/ou

q) que les îlots de contact individuels sont sensiblement rectangulaires, et/ou

r) que le revêtement des îlots de contact est constitué d'un matériau conducteur différent de celui des parties de connexion (2, 3), et/ou

s) une découpe d'ajustage est pratiquée dans l'élément résistif (6) d'un côté ou des deux côtés pour régler la valeur de résistance de la résistance de mesure du courant (1) et/ou le coefficient de température de la valeur de résistance de la résistance de mesure du courant (1),

t) **en ce que** la résistance de mesure de courant (1) possède en option des contacts de mesure de tension pour exactement deux ou exactement trois canaux de mesure,

u) **en ce qu'**il est prévu en option trois contacts de mesure de tension (9, 11, 12) qui forment une prise à trois points sur une maille fermée sur la première partie de connexion (2) d'une part et sur la deuxième partie de connexion (3) d'autre part, la prise à trois points mettant à disposition trois canaux de mesure (17-19) qui fournissent trois valeurs de mesure de tension (U12, U13, U23) afin de permettre un diagnostic d'erreur.

18. Dispositif de mesure du courant comprenant

a) une résistance de mesure de courant (1) selon l'une des revendications précédentes et
b) un dispositif de mesure de la tension (20) pour la mesure séparée de la tension dans le premier canal de mesure (17) et dans le deuxième canal de mesure (18) et, en option, en plus dans le troisième canal de mesure (19), et
c) une unité d'évaluation (21)

c1) pour déterminer le courant (I) traversant la résistance de mesure de courant (1) à partir des valeurs de mesure de tension (U12, U13, U23) dans les différents canaux de mesure (17-19), et/ou
c2) pour le diagnostic d'une erreur de mesure par une évaluation des valeurs de mesure de tension (U12, U13, U23) dans les différents canaux de mesure (17-19).

19. Dispositif de mesure de courant selon la revendication 18, **caractérisé en ce que,**

a) que le dispositif de mesure de tension (20) mesure les tensions suivantes:

U12: tension entre le premier contact de mesure de tension (9) sur la première partie de connexion (2) et le deuxième contact de mesure de tension (11) sur la deuxième partie de connexion (3),
U23: tension entre le deuxième contact de mesure de tension (11) sur la deuxième partie de connexion (3) et le troisième contact de mesure de tension (12) sur la deuxième partie de connexion (3),
U13: tension entre le premier contact de mesure de tension (9) sur la première partie de connexion (2) et le troisième contact de mesure de tension (12) sur la deuxième partie de connexion (3),

b) **en ce que** l'unité d'évaluation (21) calcule à partir des tensions U12, U23 et U13 l'écart suivant $\Delta U$ :

$$\Delta U = U12 + U23 - U13,$$

et

c) que l'unité d'évaluation génère un signal d'erreur lorsque l'écart $\Delta U$ dépasse une valeur maximale admissible.

20. Procédé de mesure de courant pour mesurer un courant électrique au moyen d'une résistance de mesure de courant (1) selon l'une des revendications 1 à 17, comprenant les étapes suivantes :

a) Faire passer le courant électrique (I) à mesurer à travers la résistance de mesure de courant (1),
b) mesurer les tensions suivantes aux bornes de la résistance de mesure de courant (1) pendant que le courant à mesurer (I) circule à travers la résistance de mesure de courant (1) :

U12 : tension entre le premier contact de mesure de tension (9) sur la première partie de connexion (2) et le deuxième contact de mesure de tension (11) sur la deuxième partie de connexion (3),
U23 : tension entre le deuxième contact de mesure de tension (11) sur la deuxième partie de connexion (3) et le troisième contact de mesure de tension (12) sur la deuxième partie de connexion (3),
U13 : tension entre le premier contact de mesure de tension (9) sur la première partie de connexion (2) et le troisième contact de mesure de tension (12) sur la deuxième partie de connexion (3),

c) calculer le courant (I) en fonction d'au moins une des tensions mesurées U12, U13, U23.

21. Procédé de mesure de courant selon la revendication 20, **caractérisé par** les étapes suivantes pour un diagnostic de défaut :

a) calculer un écart $\Delta U$ à partir des tensions U12, U23 et U13 selon la formule suivante :

$$\Delta U = U12 + U23 - U13,$$

et

b) générer un signal d'erreur lorsque l'écart $\Delta U$ dépasse une valeur maximale.

22. Procédé de mesure de courant pour mesurer un courant électrique au moyen d'une résistance de mesure de courant (1) selon l'une des revendications 1 à 17, comprenant les étapes suivantes :

a) Faire passer le courant électrique (I) à mesurer à travers la résistance de mesure de courant (1),
b) mesurer les tensions suivantes aux bornes de la résistance de mesure de courant (1) pendant que le courant à mesurer (I) circule à travers la résistance de mesure de courant (1) :

U34 : tension entre le troisième contact de mesure de tension (12) sur la deuxième partie de connexion (3) et le quatrième contact de mesure de tension (26) sur la première partie de connexion (2),
U41 : tension entre le quatrième contact de mesure de tension (26) sur la première partie de connexion (2) et le premier contact de mesure de tension (9) sur la première partie de connexion (2),
U31 : tension entre le troisième contact de mesure de tension (12) sur la deuxième partie de connexion (3) et le premier contact de mesure de tension (9) sur la première partie de connexion (2),

c) calculer le courant (I) en fonction d'au moins une des tensions mesurées U34, U41, U31.

23. Procédé de mesure de courant selon la revendication 22, **caractérisé par** les étapes suivantes pour un diagnostic d'erreur :

a) calculer un écart $\Delta U$ à partir des tensions U34, U41, U31 selon la formule suivante :

$$\Delta U = U34 + U41 - U31,$$

et

b) générer un signal d'erreur lorsque l'écart $\Delta U$ dépasse une valeur maximale.

Fig. 1A

Fig. 1B

Fig. 2A

Fig. 2B

Fig. 2C

Fig. 3

(Ursprung enspricht Übergang Widerstandselement/leitfähiger Anschluss)

Fig. 4

Fig. 5

Fig. 6

Fig. 7

Fig. 8

Fig. 9

Start
Diagnosefunktion

S1 — Durchleiten des zu messenden Stroms durch den Strommesswiderstand

S2 — Messen des Spannungsabfalls U12

S3 — Messen des Spannungsabfalls U13

S4 — Messen des Spannungsabfalls U23

S5 — Berechnung der Abweichung
$\Delta U = U12 + U23 - U13$

S6 — $|\Delta U| > |\Delta U_{MAX}|?$
N          J

S7 — Strommessung korrekt

S8 — Strommessung fehlerhaft

Ende
Diagnosefunktion

Fig. 10

Fig. 11A

Fig. 11B

Fig. 12

Fig. 13

Fig. 14

Fig. 15

Fig. 16

Fig. 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0605800 A1
- WO 2012019784 A1
- DE 102020111634 B3
- DE 102013005939 A1
- US 20170089955 A1
- DE 102017003111 A1
- DE 112018004830 T5
- EP 3671225 A1